# DEMANDE DE BREVET EUROPEEN

(11) **EP 3 826 072 A1**
(43) Date de publication de la demande: **26.05.2021**
(21) Numéro de dépôt: 20208298.8
(22) Date de dépôt: 18.11.2020
(51) Int. Cl.: H01L 29/78, H01L 29/20, H01L 29/66, H01L 29/778, H01L 29/417

(54) **TRANSISTOR A GAZ D'ELECTRONS, DISPOSITIF MONOBLOC COMPORTANT AU MOINS DEUX TRANSISTORS EN CASCODE ET PROCEDES DE FABRICATION ASSOCIES**

(30) Priorité: 20.11.2019 FR 1912957
(71) Demandeur: Commissariat à l'Energie Atomique et aux Energies Alternatives, 75015 Paris (FR)
(72) Inventeur: BUCKLEY, Julien, 38054 GRENOBLE CEDEX 9 (FR); MOHAMAD, Blend, 38054 GRENOBLE CEDEX 09 (FR); RIGAUD-MINET, Florian, 38054 GRENOBLE CEDEX 09 (FR)
(74) Mandataire: Cabinet Camus Lebkiri

(57) **Abrégé**

Un aspect de l'invention concerne un transistor (TR), comportant :
- des première (101) et deuxième couches semiconductrices (102) ;
- une troisième couche semiconductrice (103) à dopage de type P avec au moins une première zone (107) à dopage de type N ;
- au moins une deuxième zone (108) à dopage de type N ou métallique ;
- une électrode de source (S) formée sur la première zone (107) ;
- une électrode de drain (D) formée sur la première couche semiconductrice (101) ;
- une grille (G) située entre l'électrode de source (S), et la deuxième zone (108).

## Description

### DOMAINE TECHNIQUE DE L'INVENTION

Le domaine technique de l'invention est celui des transistors à gaz d'électrons et en particulier celui des transistors à gaz d'électrons de type normalement ouvert.

La présente invention concerne un transistor à gaz d'électrons et en particulier un transistor à gaz d'électrons de type normalement ouvert. La présente invention concerne également un dispositif monobloc comportant au moins deux transistors et des procédés de fabrication du dispositif monobloc.

### ARRIERE-PLAN TECHNOLOGIQUE DE L'INVENTION

De nombreuses applications électroniques nécessitent dorénavant une amélioration de performances, par exemple dans l'électronique embarquée à destination de l'automobile et des transports terrestres, dans l'aéronautique, dans les systèmes médicaux ou encore dans des solutions domotiques. Ces applications nécessitent pour la plupart des commutateurs pour forte puissance fonctionnant dans des gammes de fréquences fréquemment supérieures au mégahertz.

Historiquement, des commutateurs de puissance ont longtemps fait appel à des transistors à effet de champ basés sur un canal semi-conducteur, le plus souvent en silicium. Pour des fréquences plus faibles, les transistors à jonction étaient préférés car supportant des densités de courant plus élevées. Cependant, du fait de la tension de claquage relativement limitée de chacun de ces transistors, les applications de puissance nécessitent l'utilisation d'un grand nombre de transistors en série, ou des transistors plus longs, ce qui aboutit à une résistance en conduction plus élevée. Les pertes à travers ces transistors en série sont considérables, aussi bien en régime établi qu'en commutation.

Une alternative pour des commutateurs de puissance, notamment à hautes fréquences, est l'utilisation de transistors à effet de champ à hétérojonction, également désignés par le terme de transistor à effet de champ à hétérostructure. De tels transistors incluent notamment les transistors à gaz d'électrons.

En particulier, un transistor à gaz d'électrons comporte une superposition de deux couches semi-conductrices ayant des bandes interdites différentes qui forment un puits quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

Parmi les transistors à gaz d'électrons à large bande d'énergie interdite, les transistors à base de nitrure de gallium GaN sont très prometteurs. Leur largeur de bande d'énergie interdite induit une tension d'avalanche plus haute comparée aux matériaux classiques de l'électronique (Si, SiGe, GaAs, InP), une vitesse élevée de saturation des porteurs et de bonnes stabilités thermique et chimique (permettant une utilisation dans des environnements difficiles). Le champ de claquage du nitrure de gallium peut ainsi être supérieur à 3x10⁶ V/cm, ce qui permet aisément de réaliser des transistors avec des tensions de claquage supérieures à 100 V. De plus, de tels transistors permettent de très grandes densités de courant du fait de la très grande mobilité électronique dans le gaz d'interface.

Le nitrure de gallium présente une bande d'énergie interdite large de 3,39 eV. De plus, des alliages ternaires tels que du AIGaN ou InGaN peuvent aisément être réalisés à partir d'une machine à former du GaN par épitaxie. Un transistor à gaz d'électrons à base de nitrure de gallium peut aussi être réalisé sur un substrat en silicium (qui est le substrat de base de l'industrie du semiconducteur). Le transistor à gaz d'électrons GaN a donc un coût de production beaucoup plus faible qu'un transistor à base de SiC par exemple. Même si un transistor à base de SiC présente également une large bande d'énergie interdite, des alliages ternaires peuvent difficilement être réalisés à partir de ce matériau, et il ne peut pas être réalisé sur substrat silicium standard, ce qui rend le coût de fabrication prohibitif et en limite fortement les applications.

Pour certaines applications, notamment des applications de sécurité en vue d'isoler un circuit en cas de dysfonctionnement d'un système de commande, on utilise des transistors à gaz d'électrons du type normalement ouvert ou normalement bloqué, c'est-à-dire que leur tension de seuil de commutation est positive, de sorte que le transistor reste bloqué en l'absence de signal de commande.

Pour réaliser un transistor à gaz d'électrons GaN du type normalement ouvert, il est connu d'avoir recours à un montage cascode ou d'utiliser une architecture de grille particulière, comme décrit dans le document « IEEE Journal of emerging and selected topics in power electronics », E.A. Jones et al., vol.4, no.3, September 2016, pp.707-719.

Le montage cascode comporte un transistor à gaz d'électrons GaN normalement passant et un MOSFET normalement ouvert en série. Or, un tel montage présente une résistance élevée dans l'état passant et nécessite de nombreuses étapes de fabrication, ce qui engendre des coûts supplémentaires.

Le document décrit plusieurs architectures de grille et notamment une première architecture avec une grille en nitrure de gallium GaN dopée P, une seconde architecture avec une grille isolante avec traitement plasma CF₄ et une troisième architecture avec une grille isolante avec une gravure coupant le gaz d'électrons.

Cependant, ces architectures de grille présentent des inconvénients.

En effet, la première architecture et la troisième architecture ne permettent pas d'obtenir des valeurs de tensions de seuil élevées, à savoir au moins égales à 3 V, pour éviter que le transistor passe dans l'état passant de façon non voulue lorsque la grille subit des perturbations, et la deuxième architecture induit une dispersion des tensions de seuil dus aux mouvements des charges plasma.

Il existe donc un besoin d'obtenir un transistor à gaz d'électrons ayant une tension de seuil positive relativement élevée, non sujet à une dispersion des tensions de seuil et avec une résistance faible dans l'état passant.

### RESUME DE L'INVENTION

L'invention offre une solution aux problèmes évoqués précédemment, en proposant un transistor à gaz d'électrons normalement ouvert avec une tension de seuil supérieure à 3 V qui ne se disperse pas et avec une résistance faible en conduction.

Un premier aspect de l'invention concerne un transistor à gaz d'électrons de type normalement ouvert, comportant :
- une première couche semiconductrice agencée selon un plan de couche et une deuxième couche semiconductrice formée sur la première couche semiconductrice et agencée selon le plan de couche, les première et deuxième couches semiconductrices formant une couche de gaz d'électrons à leur interface ;
- une troisième couche semiconductrice à dopage de type P formée sur la deuxième couche semiconductrice et agencée selon le plan de couche ;
- au moins une première zone à dopage de type N dont au moins une partie est ménagée dans l'épaisseur de la troisième couche semiconductrice, la première zone délimitant une zone de source ;
- au moins une deuxième zone à dopage de type N ou métallique présentant au moins une partie ménagée dans la deuxième couche semiconductrice ;
- une électrode de source formée sur la zone de source ;
- une électrode de drain formée sur la première couche semiconductrice ; et
- une grille localisée entre l'électrode de source, et la deuxième zone.

Grâce à l'invention, la grille permet de contrôler le passage du courant entre l'électrode de source et l'électrode de drain. En effet, la grille, soit empêche dans l'état bloqué, soit permet dans l'état passant, au courant d'atteindre la deuxième zone, et d'ainsi traverser la deuxième couche semiconductrice pour atteindre l'électrode de drain via le gaz d'électrons. La troisième couche semiconductrice fortement dopée P agit comme isolant et empêche le courant de la traverser, ce qui permet d'augmenter la résistance dans l'état bloqué et également la tension de seuil de commutation. Le transistor selon l'invention a une tension de seuil supérieure à 3 V et une résistance dans l'état passant faible, comparée par exemple au montage cascode de l'art antérieur.

Outre les caractéristiques qui viennent d'être évoquées dans le paragraphe précédent, le transistor selon l'invention peut présenter une ou plusieurs caractéristiques complémentaires parmi les suivantes, considérées individuellement ou selon toutes les combinaisons techniquement possibles.

Selon une variante de réalisation, le transistor selon l'invention comporte en outre une quatrième couche semiconductrice formée sur la troisième couche semiconductrice et agencée selon le plan de couche, la zone de source et au moins une partie de la deuxième zone étant ménagées dans l'épaisseur de la quatrième couche semiconductrice.

Ainsi, la mobilité électronique sous la grille est plus élevée.

Selon une sous-variante de réalisation de la variante de réalisation précédente, la quatrième couche semiconductrice est une couche de nitrure de gallium GaN intrinsèque.

Ainsi, la quatrième couche semiconductrice ne dégrade pas la mobilité des électrons.

Selon une variante de réalisation compatible avec la variante de réalisation précédente, la première couche semiconductrice est une couche de nitrure de gallium GaN et la deuxième couche semiconductrice est une couche de nitrure d'aluminium-gallium AlGaN.

Ainsi, le transistor selon l'invention est un transistor à gaz d'électrons GaN présentant de nombreux avantages précédemment décrits.

Selon une sous-variante de réalisation de la variante de réalisation précédente, le taux d'aluminium dans la deuxième couche semiconductrice est supérieur à 20%.

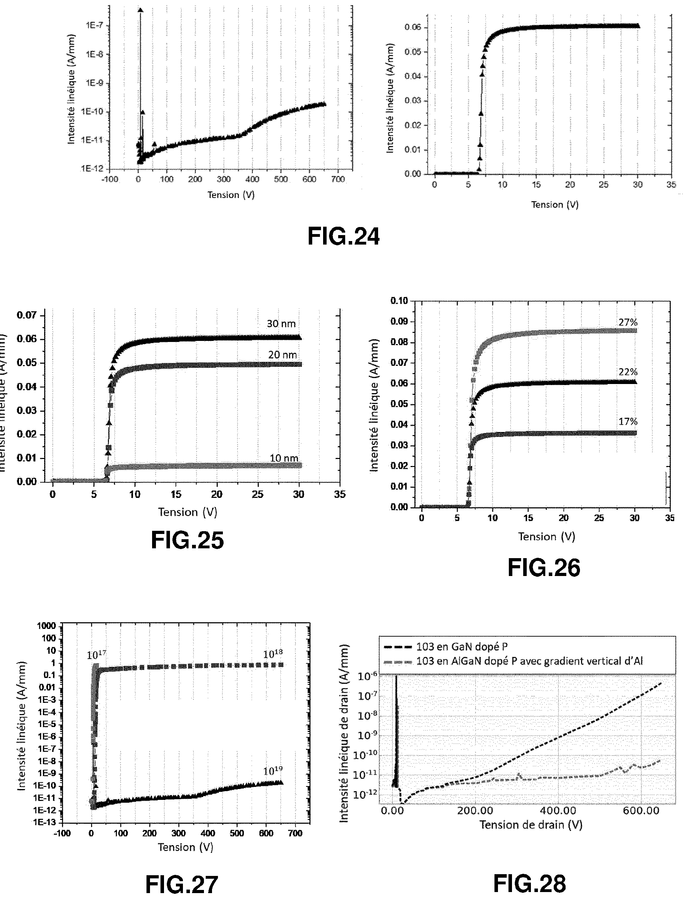

Ainsi, la résistance dans l'état passant ou résistance en conduction est diminuée, comme illustré à la figure 26.

Selon une variante de réalisation compatible avec les variantes de réalisation précédentes, la deuxième couche semiconductrice a une épaisseur supérieure à 20 nm.

Ainsi, la résistance dans l'état passant est diminuée, comme illustré à la figure 25.

Selon une variante de réalisation compatible avec les variantes de réalisation précédentes, la troisième couche semiconductrice est une couche de nitrure de gallium GaN dopée avec du magnésium Mg avec une concentration de dopants de l'ordre 10¹⁷ ou 10¹⁸ cm⁻³.

Ainsi, la résistance dans l'état bloqué est augmentée, comme illustré à la figure 27 et le risque de fuites entre l'électrode de source et l'électrode de drain est diminué.

Selon une variante de réalisation compatible avec les variantes de réalisation précédentes excepté la variante de réalisation précédente, la troisième couche semiconductrice est une couche de nitrure d'aluminium gallium AIGaN dopée avec du magnésium Mg avec une concentration de dopants de l'ordre 10¹⁷ ou 10¹⁸ cm⁻³ avec un gradient d'aluminium selon un axe perpendiculaire au plan des couches, allant d'une première fraction molaire en aluminium pour la partie de la troisième couche semiconductrice en contact avec la deuxième couche semiconductrice à une deuxième fraction molaire en aluminium inférieure à la première fraction molaire en aluminium.

Ainsi, le courant de fuite est diminué par rapport à la variante précédente dans laquelle la troisième couche semiconductrice est une couche de nitrure de gallium GaN dopée P, comme illustré sur la figure 28.

Selon une variante de réalisation compatible avec les variantes de réalisation précédentes, la première zone est dopée avec du silicium Si avec une concentration de dopants de l'ordre de 10¹⁹ cm⁻³ à 10²⁰ cm⁻³ et a une épaisseur comprise entre 10 nm et 100 nm.

Ainsi, la conductivité électrique dans la première zone est améliorée.

Selon une variante de réalisation compatible avec les variantes de réalisation précédentes, la deuxième zone à dopage de type N est dopée avec du silicium Si avec une concentration de dopants de l'ordre de 10²⁰ cm⁻³.

Ainsi, la conduction dans la deuxième zone est améliorée pour faciliter le passage des électrons.

Selon une variante de réalisation compatible avec les variantes de réalisation précédentes, la troisième couche semiconductrice a une épaisseur comprise entre 50 et 200 nm.

Ainsi, la résistance dans l'état bloqué est augmentée et les risques de fuite sont diminués.

Selon une variante de réalisation compatible avec les variantes de réalisation précédentes, la deuxième zone présente au moins une partie ménagée dans l'épaisseur des troisième, deuxième et première couche semiconductrice.

Ainsi, les électrons peuvent traverser la deuxième couche semiconductrice via la deuxième zone et atteindre le gaz d'électrons.

Selon une variante de réalisation compatible avec les variantes de réalisation précédentes excepté la variante de réalisation précédente, une première deuxième zone métallique présente au moins une partie ménagée dans l'épaisseur des deuxième et première couches semiconductrices et une deuxième deuxième zone métallique située entre la source et la première deuxième zone présente au moins une partie ménagée dans une première zone.

Ainsi, les électrons peuvent traverser une première zone pour atteindre la première deuxième zone métallique grâce à la deuxième deuxième zone métallique et la deuxième couche semiconductrice via la première deuxième zone et ainsi atteindre le gaz d'électrons.

Un deuxième aspect de l'invention concerne un dispositif monobloc comportant au moins deux transistors selon l'invention, disposés en cascode.

Selon une variante de réalisation, le dispositif monobloc comporte en outre une diode Schottky intégrée en parallèle de chaque transistor.

Ainsi, la tension à partir de laquelle le courant peut circuler entre la source et le drain de chaque transistor est plus faible.

Le dispositif selon l'invention présente quatre modes de réalisation sans diodes Schottky, correspondant au premier, deuxième, troisième et quatrième modes de réalisation, et quatre modes de réalisation avec diodes Schottky, correspondant au cinquième, sixième, septième et huitième modes de réalisation.

Les cinquième et sixième modes de réalisation peuvent être obtenus à partir des premier et deuxième modes de réalisation, le septième mode de réalisation peut être obtenu à partir du troisième mode de réalisation et le huitième mode de réalisation peut être obtenu à partir du quatrième mode de réalisation.

Dans le premier, le deuxième, le cinquième et le sixième mode de réalisation, l'électrode de source est entre la grille et l'électrode de drain. Ainsi, le champ électrique sous la grille est plus faible dans l'état bloqué car celui-ci se concentre entre l'électrode de source et l'électrode de drain. Le dispositif est également plus compact par rapport aux dispositifs des troisième, quatrième, septième et huitième modes de réalisation dans lesquels la grille est entre l'électrode de source et l'électrode de drain et l'électrode de source est commune aux deux transistors.

Un troisième aspect de l'invention concerne un procédé de fabrication d'un dispositif selon l'invention comportant les étapes suivantes :
- dépôt selon un plan de couche, d'une première, puis d'une deuxième, puis d'une troisième couche semiconductrice, puis d'une couche isolante de grille et puis d'une couche métallique de grille ;
- gravure de la couche isolante de grille et de la couche métallique de grille de manière à obtenir deux premières lignes parallèles et non confondues dans le plan de couche ;
- dopage d'au moins la troisième couche semiconductrice au niveau de zones périphériques situées de part et d'autre des deux premières lignes et agencées selon le plan de couche ;
- dopage d'au moins la troisième couche semiconductrice au niveau d'une zone centrale située entre les deux premières lignes et agencées selon le plan de couche;
- gravure des zones périphériques avec arrêt sur la deuxième couche semiconductrice de manière à conserver une deuxième ligne le long de chaque première ligne ;
- dépôt d'une couche isolante d'électrode selon le plan de couche ;
- gravure de deux deuxièmes tranchées parallèles avec arrêt sur ou dans la première couche semiconductrice dans les zones périphériques situées de part et d'autre des deux deuxièmes lignes, les deuxièmes lignes étant entre les deux deuxièmes tranchées ;
- dépôt d'une couche métallique d'électrode selon le plan de couche ;
- gravure, dite gravure d'électrodes, de la couche métallique d'électrode de manière à conserver au moins la couche métallique d'électrode au niveau des deuxièmes tranchées.

Le procédé selon l'invention présente huit modes de réalisation, un mode de réalisation par mode de réalisation du dispositif selon l'invention qu'il fabrique. Les huit modes de réalisation du procédé présentent les étapes précédemment décrites. Chaque deuxième tranchée est destinée à constituer une électrode de drain et chaque première ligne, une grille.

Selon une première variante de réalisation, le procédé selon l'invention comporte en outre une gravure d'une première tranchée dans la couche isolante d'électrode au niveau de chaque deuxième ligne, la gravure d'électrodes conservant la couche métallique d'électrode au niveau des deux premières tranchées.

Cette première variante de réalisation concerne les premier, deuxième, cinquième et sixième modes de réalisation du procédé permettant respectivement de fabriquer le dispositif selon le premier, le deuxième, le cinquième et le sixième mode de réalisation. Chaque première tranchée est destinée à constituer une électrode de source.

Selon une première sous-variante de réalisation de la première variante de réalisation précédente, le procédé selon l'invention comporte en outre les étapes suivantes :
- gravure d'une tranchée primaire dans la zone centrale avant l'étape de dépôt de la couche isolante d'électrode ;
- gravure d'une tranchée secondaire dans la tranchée primaire avec arrêt dans la première couche semiconductrice après l'étape de dépôt de la couche isolante d'électrode,
- gravure d'au moins deux tranchées tertiaires dans la zone centrale de part et d'autre de la tranchée primaire après l'étape de dépôt de la couche isolante d'électrode ;
la gravure d'électrodes conservant la couche métallique d'électrode au niveau des tranchées primaire, secondaire et tertiaires.

Cette sous-variante de réalisation concerne le deuxième, le cinquième et le sixième mode de réalisation du procédé. Les tranchées primaire, secondaire et tertiaires sont destinées à constituer une deuxième zone métallique.

Selon une deuxième variante de réalisation, le procédé selon l'invention comporte en outre, après l'étape de dépôt de la couche isolante d'électrode, une gravure d'une première tranchée dans la zone centrale, la gravure d'électrodes conservant la couche métallique d'électrode au niveau de la première tranchée.

Cette deuxième variante de réalisation concerne les troisième, quatrième, septième et huitième modes de réalisation du procédé permettant respectivement de fabriquer le dispositif selon le troisième, le quatrième, le septième et le huitième mode de réalisation. La première tranchée est destinée à constituer l'électrode de source commune aux deux transistors selon l'invention.

Selon une première sous-variante de réalisation de la deuxième variante de réalisation, le procédé selon l'invention comporte en outre les étapes suivantes, après l'étape de dépôt de la couche isolante d'électrode :
- gravure d'une tranchée primaire dans la couche isolante d'électrode au niveau de chaque deuxième ligne ;
- gravure d'une tranchée secondaire avec arrêt sur la première couche semiconductrice le long de chaque deuxième ligne,
la gravure d'électrodes conservant la couche métallique d'électrode au niveau des deux tranchées primaires et deux tranchées secondaires.

Cette sous-variante de réalisation concerne le quatrième et le huitième mode de réalisation du procédé. Les tranchées primaires sont destinées à constituer une première deuxième zone métallique et les tranchées secondaires, une deuxième deuxième zone métallique, la première deuxième zone métallique permettant de faciliter l'acheminement des électrons vers la deuxième deuxième zone métallique permettant de traverser la deuxième couche semiconductrice pour rejoindre le gaz d'électrons.

Selon une deuxième sous-variante de réalisation de la première variante de réalisation compatible avec la première sous-variante de réalisation de la première variante de réalisation, le procédé selon l'invention comporte en outre, après l'étape de dépôt de la couche isolante d'électrode, une étape de gravure de deux troisièmes tranchées parallèles dans la couche isolante d'électrode, dans les zones périphériques situées de part et d'autre des deux deuxièmes lignes, les deuxièmes lignes étant entre les deux troisièmes tranchées, les deuxièmes tranchées étant gravées de manière que les troisièmes tranchées soient entre les deuxièmes tranchées, la gravure d'électrodes conservant en outre la couche métallique d'électrode entre chaque troisième tranchée et la première tranchée la plus proche et après l'étape de gravure d'électrodes, les étapes suivantes :
- dépôt d'une couche métallique de diode selon le plan de couche ;
- gravure de la couche métallique de diode de manière à conserver au moins la couche métallique de diode au niveau de chaque troisième tranchée et entre chaque troisième tranchée et la première tranchée la plus proche.

Cette deuxième sous-variante de réalisation concerne le cinquième mode de réalisation du procédé permettant de fabriquer le dispositif selon le cinquième mode de réalisation. Chaque troisième tranchée recouverte de la couche métallique de diode et la partie recouverte de la couche métallique de diode et de la couche métallique d'électrode entre chaque troisième tranchée et la première tranchée la plus proche constitue une diode Schottky.

Selon une troisième sous-variante de réalisation de la première variante de réalisation compatible avec la première sous-variante de réalisation de la première variante de réalisation, le procédé selon l'invention comporte en outre, après l'étape de dépôt de la couche isolante d'électrode, les étapes suivantes :
- gravure de deux troisièmes tranchées parallèles dans la couche isolante d'électrode dans les zones périphériques situées de part et d'autre des deux deuxièmes lignes, les deuxièmes lignes étant entre les deux troisièmes tranchées, puis dépôt d'une couche métallique de diode selon le plan de couche ;
- gravure de la couche métallique de diode de manière à conserver au moins la couche métallique de diode au niveau de chaque troisième tranchée, entre chaque troisième tranchée et la deuxième ligne la plus proche et au niveau de chaque deuxième ligne, puis dépôt d'une couche isolante de diode selon le plan de couche ;
les deuxièmes tranchées étant gravées de manière que les troisièmes tranchées soient entre les deuxièmes tranchées, la gravure d'électrodes conservant en outre la couche métallique d'électrode au niveau de chaque troisième tranchée et entre chaque troisième tranchée et la première tranchée la plus proche.

Cette troisième sous-variante de réalisation concerne le sixième mode de réalisation du procédé permettant de fabriquer le dispositif selon le sixième mode de réalisation. Chaque troisième tranchée et la partie recouverte de la couche métallique de diode et de la couche métallique d'électrode entre chaque troisième tranchée et la première tranchée la plus proche constitue une diode Schottky.

Selon une deuxième sous-variante de réalisation de la deuxième variante de réalisation, le procédé selon l'invention comporte en outre, après l'étape de gravure d'électrodes, les étapes suivantes :
- gravure de deux troisièmes tranchées parallèles, chaque troisième tranchée étant gravée au niveau d'une deuxième ligne ;
- dépôt d'une couche métallique de diode selon le plan de couche et gravure de la couche métallique de diode de manière à conserver au moins la couche métallique de diode au niveau chaque deuxième ligne, entre chaque troisième tranchée et la première tranchée, et au niveau de la première tranchée.

Cette deuxième sous-variante de réalisation concerne le septième mode de réalisation du procédé permettant de fabriquer le dispositif selon le septième mode de réalisation. Chaque troisième tranchée et la partie recouverte de la couche métallique de diode entre chaque troisième tranchée et la première tranchée constitue une diode Schottky.

Selon une alternative de réalisation de la première sous-variante de réalisation de la deuxième variante de réalisation, le procédé selon l'invention comporte en outre, après l'étape de gravure d'électrodes, les étapes suivantes :
- dépôt d'une couche isolante de diode selon le plan de couche et gravure de deux troisièmes tranchées parallèles, chaque troisième tranchée étant gravée entre une deuxième tranchée et une tranchée secondaire, la première tranchée se trouvant entre les deux troisièmes tranchées ;
- dépôt d'une couche métallique de diode selon le plan de couche et gravure de la couche métallique de diode de manière à conserver au moins la couche métallique de diode au niveau de chaque troisième tranchée, entre chaque troisième tranchée et la première tranchée et au niveau de la première tranchée.

Cette alternative de réalisation concerne le huitième mode de réalisation du procédé permettant de fabriquer le dispositif selon le huitième mode de réalisation. Chaque troisième tranchée et la partie recouverte de la couche métallique de diode entre chaque troisième tranchée et la première tranchée constitue une diode Schottky.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 illustre la première étape du premier mode de réalisation du procédé selon l'invention.
- La figure 2 illustre la deuxième étape du premier mode de réalisation du procédé selon l'invention.
- La figure 3 illustre la troisième étape du premier mode de réalisation du procédé selon l'invention.
- La figure 4 illustre la quatrième étape du premier mode de réalisation du procédé selon l'invention.
- La figure 5 illustre la cinquième étape du premier mode de réalisation du procédé selon l'invention.
- La figure 6 illustre la sixième étape du premier mode de réalisation du procédé selon l'invention.
- La figure 7 illustre la septième étape du premier mode de réalisation du procédé selon l'invention.
- La figure 8 illustre la huitième étape du premier mode de réalisation du procédé selon l'invention.
- La figure 9 illustre la neuvième étape du premier mode de réalisation du procédé selon l'invention.
- La figure 10 illustre la dixième étape du premier mode de réalisation du procédé selon l'invention.
- La figure 11 illustre la septième étape du deuxième mode de réalisation du procédé selon l'invention.
- La figure 12 illustre la dixième étape du deuxième mode de réalisation du procédé selon l'invention.
- La figure 13 illustre la onzième étape du deuxième mode de réalisation du procédé selon l'invention.
- La figure 14 montre une représentation schématique du deuxième mode de réalisation du dispositif selon l'invention.
- La figure 15 illustre la septième étape des troisième et quatrième modes de réalisation du procédé selon l'invention.
- La figure 16 montre une représentation schématique du troisième mode de réalisation du dispositif selon l'invention.
- La figure 17 illustre la huitième étape du quatrième mode de réalisation du procédé selon l'invention.
- La figure 18 illustre la neuvième étape du quatrième mode de réalisation du procédé selon l'invention.
- La figure 19 montre une représentation schématique du quatrième mode de réalisation du dispositif selon l'invention.
- La figure 20 est un schéma synoptique illustrant les étapes du premier mode de réalisation du procédé selon l'invention.
- La figure 21 est un schéma synoptique illustrant les étapes du deuxième mode de réalisation du procédé selon l'invention.
- La figure 22 est un schéma synoptique illustrant les étapes du troisième mode de réalisation du procédé selon l'invention.
- La figure 23 est un schéma synoptique illustrant les étapes du quatrième mode de réalisation du procédé selon l'invention.
- La figure 24 représente les caractéristiques d'un transistor à gaz d'électrons dans un état bloqué (à gauche) et dans un état passant (à droite).
- La figure 25 représente les caractéristiques d'un transistor selon l'invention dans son état passant en fonction de l'épaisseur d'une deuxième couche semiconductrice.
- La figure 26 représente les caractéristiques d'un transistor selon l'invention dans son état passant en fonction du pourcentage d'aluminium dans une deuxième couche semiconductrice.
- La figure 27 représente les caractéristiques d'un transistor selon l'invention dans son état bloqué en fonction du dopage de type P dans une troisième couche semiconductrice.
- La figure 28 représente le courant de fuite d'un transistor selon l'invention présentant une troisième couche semiconductrice en nitrure de gallium GaN dopé P et d'un transistor selon l'invention présentant une troisième couche semiconductrice en nitrure d'aluminium-gallium GaN dopé P avec un gradient d'aluminium vertical.
- La figure 29 illustre la neuvième étape d'une première variante de réalisation du cinquième mode de réalisation du procédé selon l'invention.
- La figure 30 illustre la douzième étape de la première variante de réalisation du cinquième mode de réalisation du procédé selon l'invention.
- La figure 31 illustre la treizième étape de la première variante de réalisation du cinquième mode de réalisation du procédé selon l'invention.
- La figure 32 illustre la septième étape d'une première variante de réalisation du sixième mode de réalisation du procédé selon l'invention.
- La figure 33 illustre la huitième étape de la première variante de réalisation du sixième mode de réalisation du procédé selon l'invention.
- La figure 34 montre une représentation schématique d'une première variante de réalisation du sixième mode de réalisation du dispositif selon l'invention
- La figure 35 est un schéma synoptique illustrant les étapes de la première variante de réalisation du cinquième mode de réalisation du procédé selon l'invention.
- La figure 36 est un schéma synoptique illustrant les étapes de la première variante de réalisation du sixième mode de réalisation du procédé selon l'invention.
- La figure 37 illustre la onzième étape d'un septième mode de réalisation du procédé selon l'invention.
- La figure 38 illustre la douzième étape d'un septième mode de réalisation du procédé selon l'invention.
- La figure 39 illustre la treizième étape d'un huitième mode de réalisation du procédé selon l'invention.
- La figure 40 illustre la quatorzième étape d'un huitième mode de réalisation du procédé selon l'invention.
- La figure 41 est un schéma synoptique illustrant les étapes du septième mode de réalisation du procédé selon l'invention.
- La figure 42 est un schéma synoptique illustrant les étapes du huitième mode de réalisation du procédé selon l'invention.

### DESCRIPTION DETAILLEE

Sauf précision contraire, un même élément apparaissant sur des figures différentes présente une référence unique.

Un premier aspect de l'invention concerne un transistor à gaz d'électrons, de type normalement ouvert, c'est-à-dire avec une tension de seuil de commutation positive.

On entend par « tension de seuil de commutation », la tension à appliquer entre la grille et la source du transistor pour qu'il passe d'un état bloqué à un état passant.

[Fig. 24] La figure 24 représente la caractéristique d'un transistor à gaz d'électrons dans un état bloqué à gauche et la caractéristique du même transistor à gaz d'électrons dans un état passant à droite.

Dans l'état bloqué, l'intensité traversant le transistor est très faible comparée à l'intensité traversant le transistor dans l'état passant, de l'ordre de 10¹⁰ fois plus faible, pour des tensions plus élevées, de l'ordre de dix fois plus élevées. Dans l'état bloqué, le transistor a donc une résistance très élevée bloquant le courant et dans l'état passant, une résistance faible permettant la conduction du courant.

Un deuxième aspect de l'invention concerne un dispositif monobloc comportant au moins deux transistors en cascode, c'est-à-dire deux transistors en série traversés par le même courant.

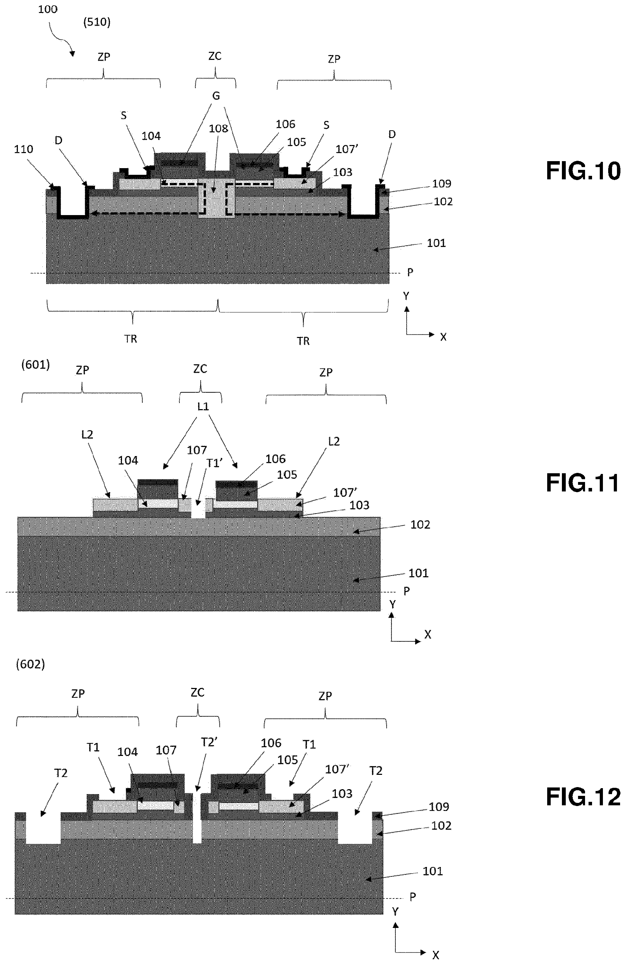

[Fig. 11] La figure 11 montre une représentation schématique d'un premier mode de réalisation du dispositif 100 selon l'invention.

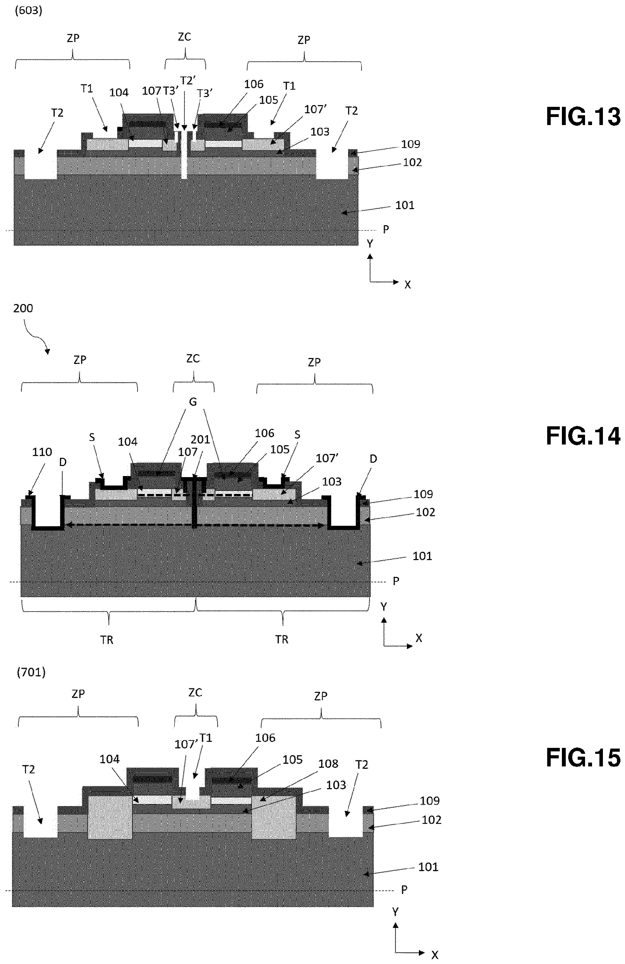

[Fig. 14] La figure 14 montre une représentation schématique d'un deuxième mode de réalisation du dispositif 200 selon l'invention.

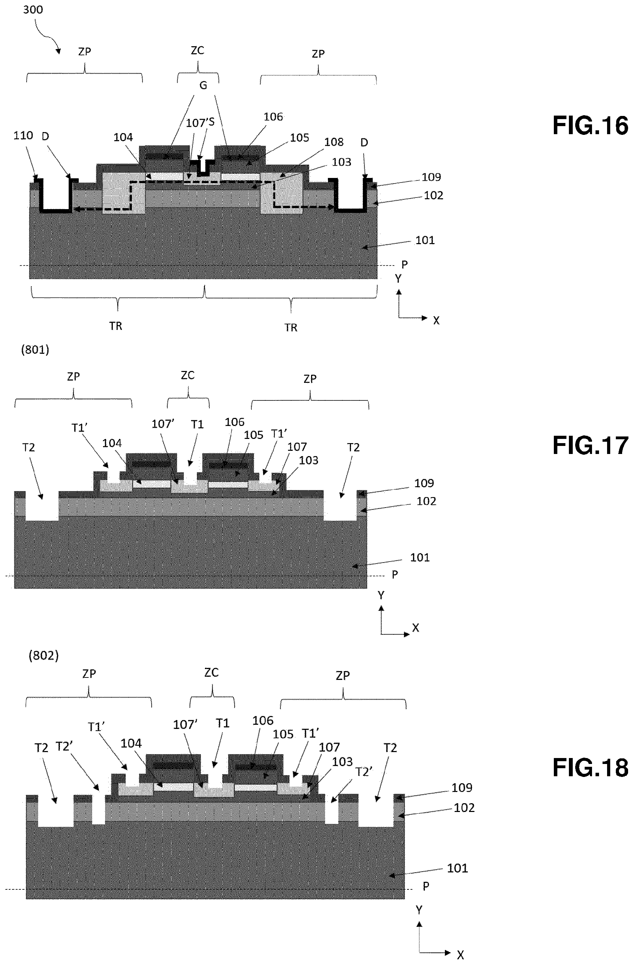

[Fig. 16] La figure 16 montre une représentation schématique d'un troisième mode de réalisation du dispositif 300 selon l'invention.

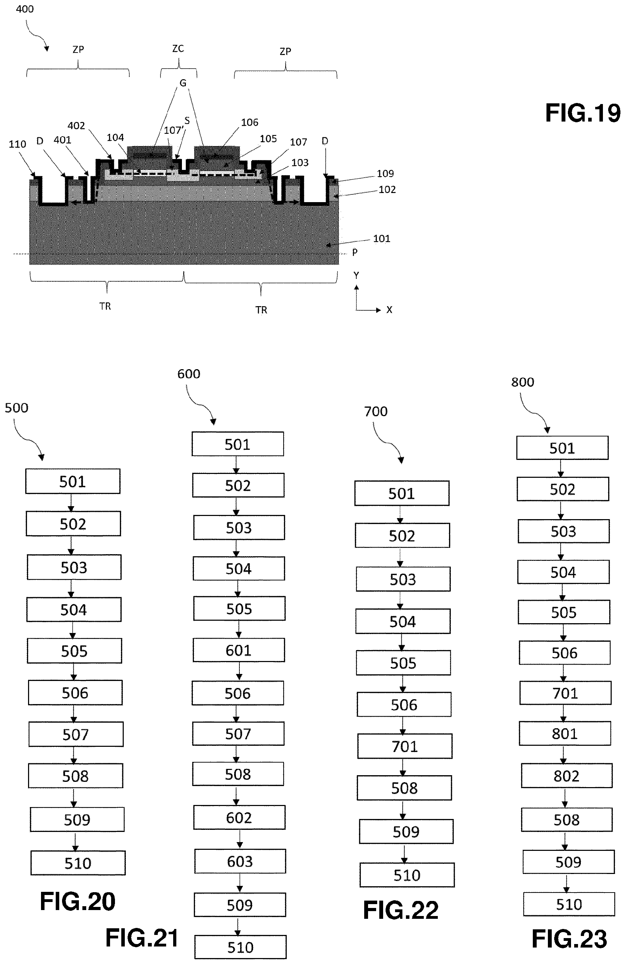

[Fig. 19] La figure 19 montre une représentation schématique d'un quatrième mode de réalisation du dispositif 400 selon l'invention.

Quel que soit le mode de réalisation, le dispositif 100, 200, 300, 400 selon l'invention comporte au moins deux transistors TR symétriques par rapport à un plan perpendiculaire à un plan de couche P et comportant un axe vertical Y. Le plan de couche P comporte un axe horizontal X et est perpendiculaire à l'axe vertical Y.

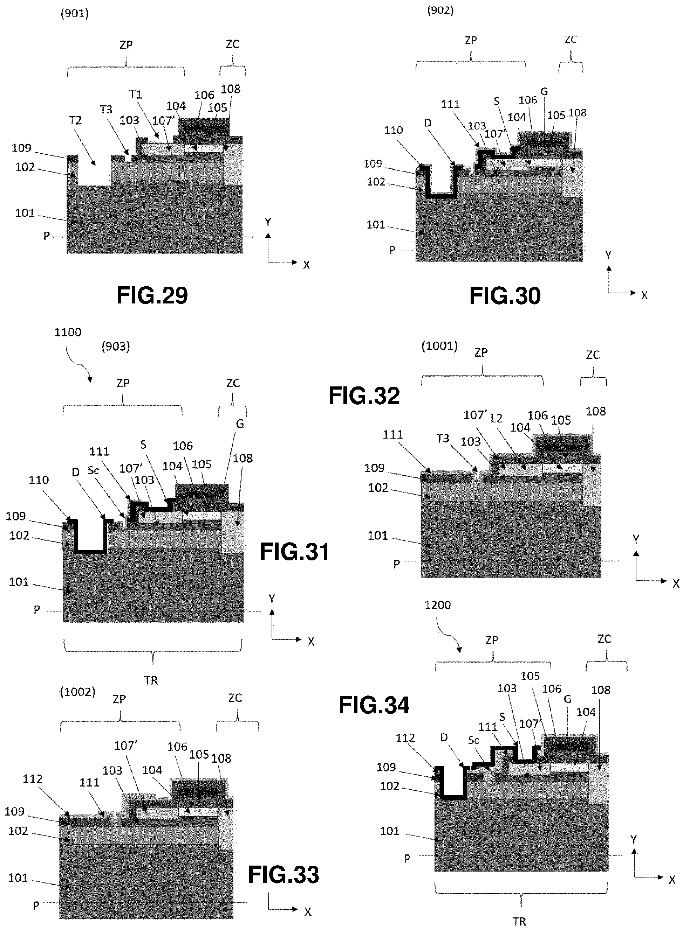

Par souci de simplicité, les figures 29 à 34 et 37 à 40 ne représentent qu'un transistor TR du dispositif, le dispositif complet pouvant être obtenu par symétrie axiale.

Dans la suite de la description, on entend par « épaisseur d'une couche », la dimension de la couche selon la direction verticale Y perpendiculaire au plan de couche P.

Chaque transistor TR comporte au moins :
- une première couche semiconductrice 101 agencée selon le plan de couche P ;
- une deuxième couche semiconductrice 102 formée sur la première couche semiconductrice 101 et agencée selon le plan de couche P ;
- une troisième couche semiconductrice 103 formée sur la deuxième couche semiconductrice 102 et agencée selon le plan de couche P ;
- au moins une première zone 107, 107' à dopage de type N, l'une des premières zones 107 délimitant une zone de source 107' ;
- au moins une deuxième zone 108, 201, 401, 402 à dopage de type N ou métallique ;
- une électrode de source S ;
- une électrode de drain D ;
- une grille G,
les couches semiconductrices 101, 102, 103 étant communes aux deux transistors TR du dispositif 100, 200, 300, 400.

Le gaz d'électrons caractéristique des transistors à gaz d'électrons est formé à l'interface entre la première couche semiconductrice 101 et la deuxième couche semiconductrice 102.

La première couche semiconductrice 101 est par exemple en nitrure de gallium GaN et la deuxième couche semiconductrice 102 en nitrure d'aluminium gallium AIGaN.

Le taux d'aluminium dans la deuxième couche semiconductrice 102 est par exemple supérieure à 20%.

La première couche semiconductrice 101 a par exemple une épaisseur comprise entre 50 nm et 300 nm et la deuxième couche semiconductrice 102 a par exemple une épaisseur supérieure à 20 nm.

La troisième couche semiconductrice 103 présente un dopage de type P.

La troisième couche semiconductrice 103 est par exemple du nitrure de gallium GaN dopé avec du magnésium Mg avec une concentration en dopants de l'ordre de 10¹⁷ ou 10¹⁸ cm⁻³.

La troisième couche semiconductrice 103 est par exemple du nitrure d'aluminium gallium AIGaN avec un gradient d'aluminium selon l'axe vertical Y perpendiculaire au plan des couches P, dopé avec du magnésium Mg avec une concentration en dopants de l'ordre de 10¹⁷ ou 10¹⁸ cm⁻³.

La fraction molaire d'aluminium pour la partie basse de la troisième couche semiconductrice 103 en contact avec la deuxième couche semiconductrice 102, ou première fraction molaire d'aluminium, est inférieure à la fraction molaire d'aluminium pour la partie haute de la troisième couche semiconductrice 103, ou deuxième fraction molaire d'aluminium.

La première fraction molaire d'aluminium est par exemple de l'ordre de la fraction molaire d'aluminium de la deuxième couche semi-conductrice 102. La première fraction molaire d'aluminium est préférentiellement égale à la fraction molaire d'aluminium de la deuxième couche semi-conductrice 102.

La deuxième fraction molaire d'aluminium est par exemple nulle.

La troisième couche semiconductrice 103 est alors réalisée par des techniques connues, par exemple par croissance par épitaxie.

La troisième couche semiconductrice 103 a par exemple une épaisseur comprise entre 25 et 100 nm, plus particulièrement entre 50 et 100 nm.

Chaque première zone 107, 107' présente au moins une partie ménagée dans l'épaisseur de la troisième couche semiconductrice 103, autrement dit une partie de la troisième couche semiconductrice 103 présente un dopage de type N.

Chaque première zone 107, 107' est par exemple dopée avec du silicium Si ou du germanium Ge, par exemple avec une concentration en dopants de l'ordre de 10¹⁹ cm⁻³ à 10²⁰ cm⁻³.

La première zone 107, 107' a par exemple une épaisseur de 20 nm à 70 nm.

Dans le premier et le troisième mode de réalisation, chaque transistor TR du dispositif 100, 300 comporte une unique première zone 107, 107' délimitant la zone de source 107' et dans le deuxième et la quatrième mode de réalisation, chaque transistor TR du dispositif 200, 400 comporte deux premières zones 107, 107' dont l'une délimite la zone de source 107'.

L'électrode de source S est formée sur la zone de source 107'.

L'électrode de drain D est formée sur ou dans la première couche semiconductrice 101.

La grille G est formée sur une partie de la troisième couche semiconductrice 103 non dopée N, c'est-à-dire ne faisant pas partie d'une première zone 107.

Chaque transistor TR peut également comporter une quatrième couche semiconductrice 104 formée sur la troisième couche semiconductrice 103 et agencée selon le plan de couche P.

Dans ce cas :
- chaque première zone 107 est ménagée dans l'épaisseur de la quatrième couche semiconductrice 104, c'est-à-dire qu'au niveau de chaque première zone 107, 107', toute la quatrième couche semiconductrice 104 est dopée N ;
- la grille G est formée sur une partie de la quatrième couche semiconductrice 104 ne faisant pas partie d'une première zone 107, 107' et donc sur la partie de la troisième couche semiconductrice 103 sur laquelle est formée la partie de la quatrième couche semiconductrice 104.

La quatrième couche semiconductrice 104 est par exemple en nitrure de gallium GaN intrinsèque.

La quatrième couche semiconductrice 104 peut également être dopée, avec une concentration en dopants de l'ordre de 10¹⁴ ou 10¹⁵ cm⁻³.

Selon un premier mode de réalisation du transistor TR selon l'invention, le transistor TR comporte une unique deuxième zone 108 à dopage de type N avec une concentration en dopants supérieure à celle de la première zone 107.

La deuxième zone 108 est par exemple dopée avec du silicium Si, par exemple avec une concentration de l'ordre de 10²⁰ cm⁻³.

Selon le premier mode de réalisation du transistor TR, la deuxième zone 108 présente au moins une partie ménagée dans l'épaisseur de la troisième couche semiconductrice 103, de la deuxième couche semiconductrice 102 et dans une partie de l'épaisseur de la première couche semiconductrice 101, c'est-à-dire qu'au niveau de la deuxième zone 108, toute la troisième couche semiconductrice 103, toute la deuxième couche semiconductrice 102 et une partie de la première couche semiconductrice 101 sont dopées N.

Si le transistor TR selon le premier mode de réalisation comporte la quatrième couche semiconductrice 104, la deuxième zone 108 est ménagée dans l'épaisseur de la quatrième couche semiconductrice 104, c'est-à-dire qu'au niveau de la deuxième zone 108, toute la quatrième couche semiconductrice 104 est dopée N.

Le dispositif 100 selon un premier mode de réalisation et le dispositif 300 selon un troisième mode de réalisation comportent des transistors TR selon le premier mode de réalisation.

Selon un deuxième mode de réalisation du transistor TR selon l'invention, le transistor TR comporte au moins une deuxième zone 201, 401, 402 métallique.

Le dispositif 200 selon un deuxième mode de réalisation et le dispositif 400 selon un quatrième mode de réalisation comportent des transistors TR selon le deuxième mode de réalisation.

Dans le deuxième mode de réalisation du dispositif 200 selon l'invention, chaque transistor TR comporte une unique deuxième zone 201.

La deuxième zone 201 est ménagée dans l'épaisseur de la troisième couche semiconductrice 103, de la deuxième couche semiconductrice 102 et dans une partie de l'épaisseur de la première couche semiconductrice 101, c'est-à-dire qu'au niveau de la deuxième zone 201, toute la troisième couche semiconductrice 103, toute la deuxième couche semiconductrice 102 et une partie de la première couche semiconductrice 101 présentent une partie métallique.

Si le transistor TR comporte la quatrième couche semiconductrice 104, la deuxième zone 201 est ménagée dans l'épaisseur de la quatrième couche semiconductrice 104, c'est-à-dire qu'au niveau de la deuxième zone 201, toute la quatrième couche semiconductrice 104 présente une partie métallique.

Dans le quatrième mode de réalisation du dispositif 400 selon l'invention, chaque transistor TR comporte deux deuxièmes zones 401, 402.

Une première deuxième zone 401 est ménagée dans l'épaisseur de la deuxième couche semiconductrice 102 et dans une partie de l'épaisseur de la première couche semiconductrice 101, c'est-à-dire qu'au niveau de la deuxième zone 401, toute la deuxième couche semiconductrice 102 et une partie de la première couche semiconductrice 101 présentent une partie métallique, et une deuxième deuxième zone 402 présente au moins une partie en contact avec une première zone 107, 107' située entre la source S et la première deuxième zone 401.

Dans le transistor TR, la grille G est située entre l'électrode de source S et la deuxième zone 108, 201, 401, 402.

Un troisième aspect de l'invention concerne un procédé de fabrication d'un dispositif 100, 200, 300, 400 selon l'invention.

[Fig. 20] La figure 20 est un schéma synoptique illustrant les étapes d'un premier mode de réalisation du procédé 500 selon l'invention, permettant de fabriquer le dispositif 100 selon le premier mode de réalisation.

[Fig. 21] La figure 21 est un schéma synoptique illustrant les étapes d'un deuxième mode de réalisation du procédé 600 selon l'invention, permettant de fabriquer le dispositif 200 selon le deuxième mode de réalisation.

[Fig. 22] La figure 22 est un schéma synoptique illustrant les étapes d'un troisième mode de réalisation du procédé 700 selon l'invention, permettant de fabriquer le dispositif 300 selon le troisième mode de réalisation.

[Fig. 23] La figure 23 est un schéma synoptique illustrant les étapes d'un quatrième mode de réalisation du procédé 800 selon de l'invention, permettant de fabriquer le dispositif 400 selon le quatrième mode de réalisation.

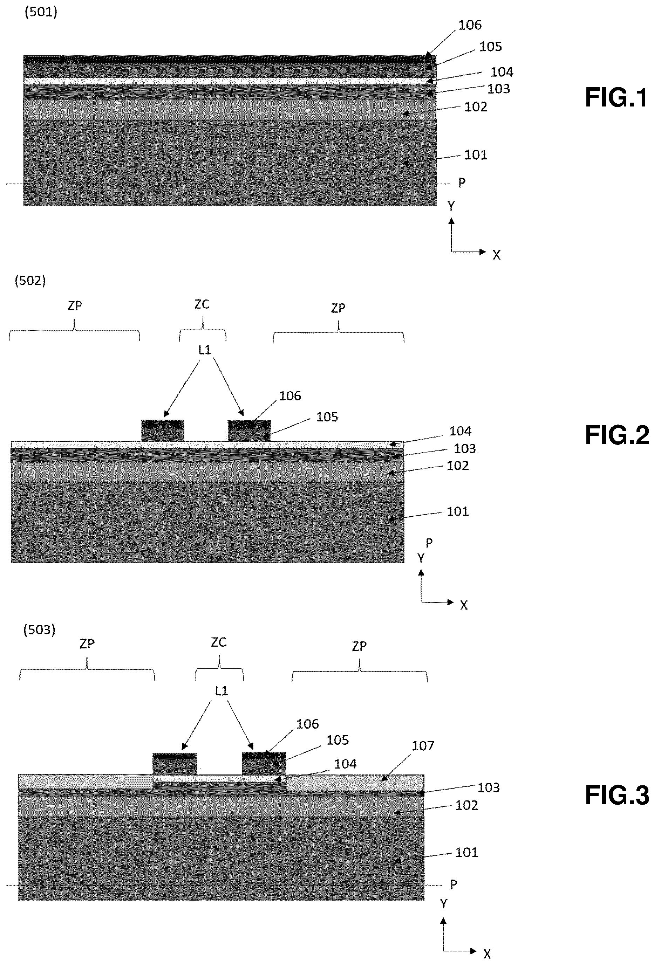

[Fig. 1] La figure 1 illustre une première étape 501 du premier mode de réalisation du procédé 500 selon l'invention quel que soit le mode de réalisation.

La première étape 501 consiste en un dépôt sur un substrat non représenté, selon le plan de couche P, de la première couche semiconductrice 101, de la deuxième couche semiconductrice 102, de la troisième couche semiconductrice 103, éventuellement de la quatrième couche semiconductrice 104, d'une couche isolante de grille 105 et d'une couche métallique de grille 106 dans cet ordre.

Dans les figures 1 à 23, le dispositif 100, 200, 300, 400 est représenté avec la quatrième couche semiconductrice 104 optionnelle.

Le dépôt est par exemple réalisé par épitaxie, par CVD pour « Chemical Vapor Déposition » ou encore par ALD pour « Atomic Layer Deposition ».

La couche isolante de grille 105 a par exemple une épaisseur comprise entre 10 nm et 80 nm et la couche métallique de grille 106 a par exemple une épaisseur comprise entre 10 nm et 200 nm.

La couche isolante de grille 105 est par exemple en nitrure de silicium SiN ou en Al₂O₃ ou en HfO₂ et la couche métallique de grille 106 est par exemple en TiN ou en Al poly-Si dopé type p.

[Fig. 2] La figure 2 illustre une deuxième étape 502 du procédé 500, 600, 700, 800 selon l'invention quel que soit le mode de réalisation.

La deuxième étape 502 consiste à graver la couche isolante de grille 105 et la couche métallique de grille 106 avec arrêt sur la quatrième couche semiconductrice 104, ou à défaut avec arrêt sur la troisième couche semiconductrice 103, de manière à obtenir deux premières lignes L1 parallèles et non confondues dans le plan de couche P.

La gravure est par exemple réalisée par gravure plasma sèche fluorée.

Les premières lignes L1 sont par exemple espacées entre elles de 50 nm à 0,5 µm et ont une largeur de 100 nm à 1 µm.

[Fig. 3] La figure 3 illustre une troisième étape 503 du procédé 500, 600, 700, 800 selon l'invention quel que soit le mode de réalisation.

La troisième étape 503 consiste à doper des zones périphériques ZP situées de part et d'autre des deux premières lignes L1 comportant les parties de la quatrième couche semiconductrice 104, ou à défaut de la troisième couche semiconductrice 103, mises à nu à la deuxième étape 502.

On entend par « parties situées de part et d'autre de deux lignes », les parties qui ne sont pas situées entre les deux lignes ou sur les deux lignes.

Le dopage est par exemple réalisé par implantation ionique d'une dose de 2x10¹⁵ cm² à 40 keV. Il est alors suivi d'un recuit de température 1000°C ou au-dessus pendant environ 30 min.

Dans les premier, deuxième et quatrième modes de réalisation du procédé 500, 600, 800, la troisième étape 503 permet la création des premières zones 107.

Dans le troisième mode de réalisation du procédé 700, la troisième étape 503 permet la création des deuxièmes zones 108 à dopage de type N.

Les caractéristiques du dopage de la troisième étape 503 sont donc différentes selon le mode de réalisation du procédé 500, 600, 700, 800. Ainsi, dans le troisième mode de réalisation du procédé 700, la dose implantée sera supérieure à la dose implantée dans les premier, deuxième et quatrième modes de réalisation.

Sur la figure 3, le dopage réalisé permet la création des premières zones 107.

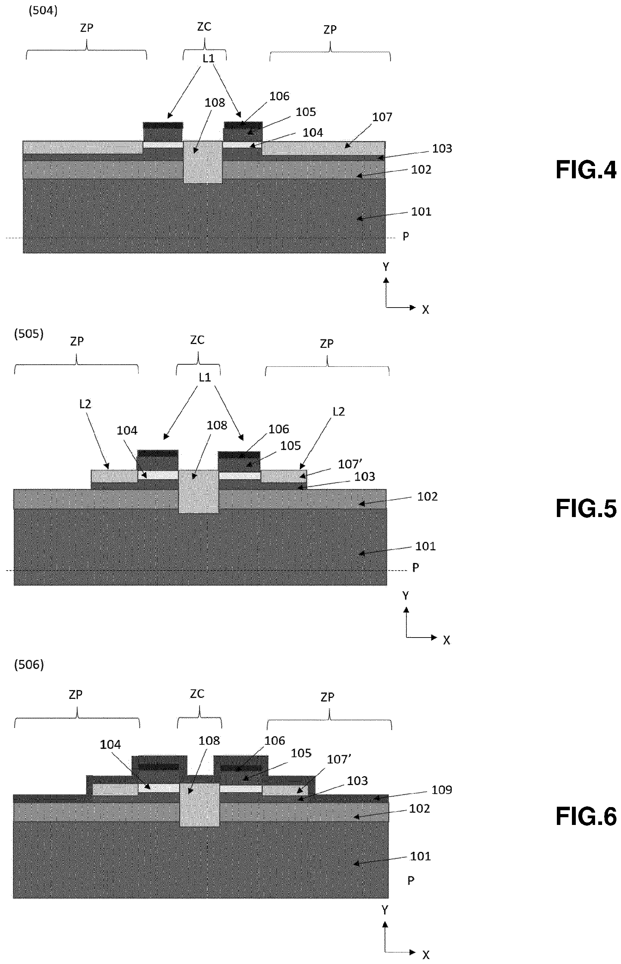

[Fig. 4] La figure 4 illustre une quatrième étape 504 du procédé 500, 600, 700, 800 selon l'invention quel que soit le mode de réalisation.

La quatrième étape 504 consiste à doper une zone centrale ZC situées entre les deux premières lignes L1 comportant les parties de la quatrième couche semiconductrice 104 mises à nu à la deuxième étape 502.

Le dopage est par exemple réalisé par implantation ionique. Il est alors suivi d'un recuit.

Dans les deuxième, troisième et quatrième modes de réalisation du procédé 600, 700, 800, la quatrième étape 504 permet la création des premières zones 107.

Dans le premier mode de réalisation du procédé 500, la quatrième étape 504 permet la création d'une deuxième zone 108 à dopage de type N.

Les caractéristiques du dopage de la quatrième étape 504 sont donc différentes selon le mode de réalisation du procédé 500, 600, 700, 800 selon l'invention. Ainsi, dans le premier mode de réalisation du procédé 500, la dose implantée sera supérieure à la dose implantée dans les deuxième, troisième et quatrième modes de réalisation.

Sur la figure 4, le dopage réalisé permet la création d'une deuxième zone 108 à dopage de type N.

[Fig. 5] La figure 5 illustre une cinquième étape 505 du procédé 500, 600, 700, 800 selon l'invention quel que soit le mode de réalisation.

La cinquième étape 505 consiste à graver les parties de la quatrième couche semiconductrice 104, et/ou à défaut, de la troisième couche semiconductrice 103, dopées lors de la troisième étape 503, c'est-à-dire les zones périphériques ZP, avec arrêt sur la deuxième couche semiconductrice 102, de manière à conserver deux deuxièmes lignes L2 le long des deux premières lignes L1. Les deuxièmes lignes L2 sont donc parallèles entre elles et parallèles aux premières lignes L1 dans le plan de couche P.

La gravure est par exemple réalisée par gravure sèche sous plasma fluoré.

Les deuxièmes lignes L2 sont par exemple espacées de 250 nm à 3 µm et ont une largeur de 1 µm à 10 µm.

[Fig. 6] La figure 6 illustre une sixième étape 506 du procédé 500, 700, 800 selon les premier, troisième et quatrième modes de réalisation.

La sixième étape 506 consiste à déposer une couche isolante d'électrode 109 selon le plan de couche P.

La couche isolante d'électrode 109 est par exemple en nitrure de silicium SiN et a par exemple une épaisseur de 30 nm.

La couche isolante d'électrode 109 est par exemple obtenue par dépôt LPCVD d'une souche de SiN.

[Fig. 11] La sixième étape 506 est également réalisée dans le procédé 600 selon le deuxième mode de réalisation mais celle-ci est précédée d'une étape 601 illustrée sur la figure 11.

L'étape 601 illustrée à la figure 11 consiste à graver une tranchée primaire T1' avec arrêt sur la deuxième couche semiconductrice 102, dans les parties mises à nu à la deuxième étape 502 et situées entre les deux premières lignes L1, c'est-à-dire dans la zone centrale ZC. La tranchée primaire T1' est parallèle aux premières lignes L1 dans le plan de couche P.

La tranchée primaire T1' est gravée de manière que les bords de cette tranchée primaire T1' soient sensiblement de même hauteur et que les flancs de la tranchée primaire T1' soient compris dans des plans orthogonaux au fond de la tranchée primaire T1' et sensiblement parallèles entre eux.

La gravure suivant une étape de photo-lithographie peut être réalisée par voie sèche sous plasma fluoré.

La tranchée primaire T1' a par exemple une largeur de 0,5 µm à 9 µm.

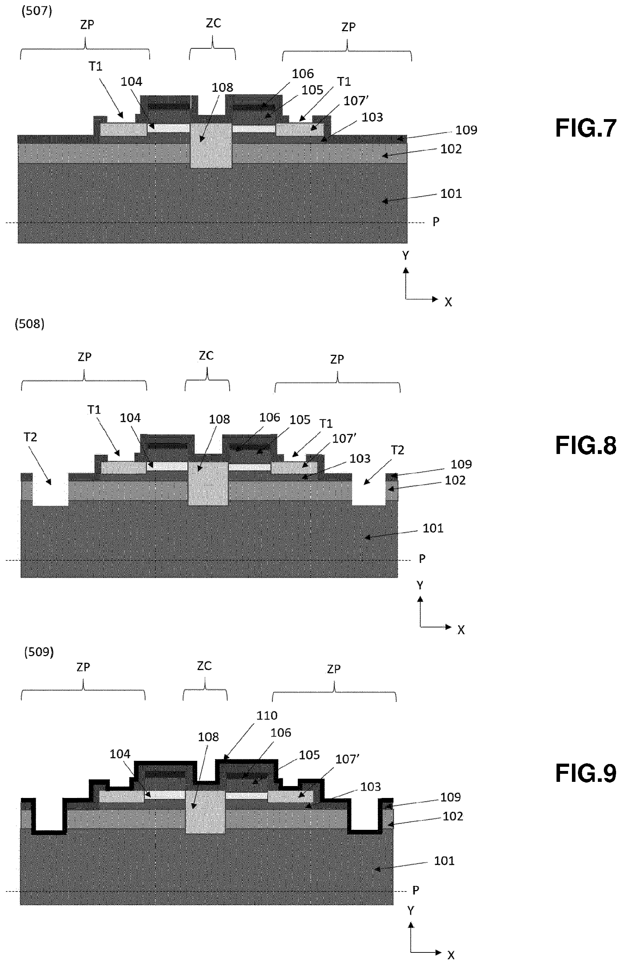

[Fig. 7] La figure 7 illustre une septième étape 507 du procédé 500 selon le premier mode de réalisation.

La septième étape 507 consiste à graver deux premières tranchées T1, une première tranchée T1 dans chaque deuxième ligne L2, avec arrêt sur la quatrième couche semiconductrice 104, ou à défaut avec arrêt sur la troisième couche semiconductrice 103. Les premières tranchées T1 sont parallèles aux premières lignes L1 dans le plan de couche P.

Les premières tranchées T1 sont parallèles entre elles. Une première tranchée T1 est gravée de manière que les bords de cette première tranchée T1 soient sensiblement de même hauteur et que les flancs de la première tranchée T1 soient compris dans des plans orthogonaux au fond de la première tranchée T1 et sensiblement parallèles entre eux. La profondeur de gravure est sensiblement la même pour les deux premières tranchées T1.

La gravure suivant une étape de photo-lithographie peut être réalisée par voie sèche sous plasma fluoré.

Les deux premières tranchées T1 ont par exemple une largeur de 0,5 µm à 10 µm.

La septième étape 507 est également réalisée dans le procédé 600 selon le deuxième mode de réalisation après la sixième étape 506.

La septième étape 507 n'est pas réalisée dans le procédé 700, 800 selon les troisième et quatrième modes de réalisation. Une septième étape bis est réalisée à sa place.

[Fig. 15] La figure 15 illustre la septième étape bis 701 du procédé 700, 800 selon les troisième et quatrième modes de réalisation.

La septième étape bis 701 consiste à graver une première tranchée T1 dans les parties de la quatrième couche semiconductrice 104, ou à défaut de la troisième couche semiconductrice 103, mises à nu à la deuxième étape 502 situées entre les deux premières lignes L1, c'est-à-dire dans la zone centrale ZC. La première tranchée T1 est parallèles aux premières lignes L1 dans le plan de couche P.

La première tranchée T1 est gravée de manière que les bords de cette première tranchée T1 soient sensiblement de même hauteur et que les flancs de la première tranchée T1 soient compris dans des plans orthogonaux au fond de la première tranchée T1 et sensiblement parallèles entre eux.

La gravure suivant une étape de photo-lithographie peut être réalisée par voie sèche sous plasma fluoré.

La première tranchée T1 a par exemple une largeur de 0,5 µm à 10 µm.

[Fig. 8] La figure 8 illustre une huitième étape 508 du procédé 500 selon le premier mode de réalisation.

La huitième étape 508 consiste à graver deux deuxièmes tranchées T2 parallèles avec arrêt sur la première couche semiconductrice 101 dans les parties des zones périphériques ZP situées de part et d'autre des deux deuxièmes lignes L2, les deux deuxièmes tranchées T2 étant séparées par les deux deuxièmes lignes L2. Les deuxièmes tranchées T2 sont parallèles aux premières lignes L1 dans le plan de couche P.

Les deuxièmes tranchées T2 sont parallèles entre elles. Une deuxième tranchée T2 est gravée de manière que les bords de cette deuxième tranchée T2 soient sensiblement de même hauteur et que les flancs de la deuxième tranchée T2 soient compris dans des plans orthogonaux au fond de la deuxième tranchée T2 et sensiblement parallèles entre eux. La profondeur de gravure est sensiblement la même pour les deux deuxièmes tranchées T2.

La gravure suivant une étape de photo-lithographie peut être réalisée par voie sèche sous plasma fluoré.

Les deux deuxièmes tranchées T2 ont par exemple une largeur de 0,5 µm à 10 µm.

La huitième étape 508 est également réalisée dans le procédé 600 selon le deuxième mode de réalisation après la septième étape 507 et dans le procédé 700 selon le troisième mode de réalisation après la septième étape bis 701.

[Fig. 17] La huitième étape 508 est également réalisée dans le procédé 800 selon le quatrième mode de réalisation, après une étape 801 illustrée sur la figure 17 et une étape 802 illustrée sur la figure 18.

L'étape 801 illustrée à la figure 17 consiste à graver deux tranchées primaires T1' dans la couche isolante d'électrode 109 et dans une partie de la quatrième couche semiconductrice 104, ou à défaut de la troisième couche semiconductrice 103 dopée lors de la troisième étape 503, au niveau des deuxièmes lignes L2. Les tranchées primaires T1' sont parallèles aux premières lignes L1 dans le plan de couche P.

Les tranchées primaires T1' sont parallèles entre elles. Une tranchée primaire T1' est gravée de manière que les bords de cette tranchée primaire T1' soient sensiblement de même hauteur et que les flancs de la tranchée primaire T1' soient compris dans des plans orthogonaux au fond de la tranchée primaire T1' et sensiblement parallèles entre eux. La profondeur de gravure est sensiblement la même pour les deux tranchées primaires T1'.

La gravure suivant une étape de photo-lithographie peut être réalisée par voie sèche sous plasma fluoré.

Les deux tranchées primaires T1' ont par exemple une largeur de 0,5 µm à 10 µm.

[Fig. 18] L'étape 802 illustrée à la figure 18 consiste à graver deux tranchées secondaires T2' avec arrêt sur la première couche semiconductrice 101 le long des deux deuxièmes lignes L2, c'est-à-dire dans les zones périphériques ZP. Les tranchées secondaires T2' sont parallèles aux premières lignes L1 dans le plan de couche P.

Les tranchées secondaires T2' sont parallèles entre elles. Une tranchée secondaire T2' est gravée de manière que les bords de cette tranchée secondaire T2' soient sensiblement de même hauteur et que les flancs de la tranchée secondaire T2' soient compris dans des plans orthogonaux au fond de la secondaire T2' et sensiblement parallèles entre eux. La profondeur de gravure est sensiblement la même pour les deux tranchées secondaires T2'.

La gravure suivant une étape de photo-lithographie peut être réalisée par voie sèche sous plasma fluoré.

Les deux tranchées secondaires T2' ont par exemple une largeur de 0,5 µm à 10 µm.

[Fig. 9] La figure 9 illustre une neuvième étape 509 du procédé 500 selon le premier mode de réalisation.

La neuvième étape 509 consiste à réaliser un dépôt conforme d'une couche métallique d'électrode 110.

Le dépôt est par exemple réalisé par épitaxie, par CVD pour « Chemical Vapor Déposition » ou encore par ALD pour « Atomic Layer Deposition ».

La couche métallique d'électrode 110 est par exemple en TiN ou en Ti et a une épaisseur comprise entre 50 nm et 100 nm.

La neuvième étape 509 est également réalisée dans le procédé 700 selon le troisième mode de réalisation et dans le procédé 800 selon le quatrième mode de réalisation après la huitième étape 508.

[Fig. 12] La neuvième étape 509 est également réalisée dans le procédé 600 selon le deuxième mode de réalisation, après une étape 602 illustrée sur la figure 12 et une étape 603 illustrée sur la figure 13.

L'étape 602 illustrée à la figure 12 consiste à graver une tranchée secondaire T2' dans la tranchée primaire gravée à l'étape 601 illustrée sur la figure 11 avec arrêt dans la première couche semiconductrice 101. La tranchée secondaire T2' est parallèle aux premières lignes L1 dans le plan de couche P.

Une tranchée secondaire T2' est gravée de manière que les bords de cette tranchée secondaire T2' soient sensiblement de même hauteur et que les flancs de la tranchée secondaire T2' soient compris dans des plans orthogonaux au fond de la secondaire T2' et sensiblement parallèles entre eux.

La gravure suivant une étape de photo-lithographie peut être réalisée par voie sèche sous plasma fluoré.

La tranchée secondaires T2' a par exemple une largeur de 0,5 µm à 10 µm.

[Fig. 13] L'étape 603 illustrée à la figure 13 consiste à graver au moins deux tranchées tertiaires T3' dans la zone centrale de part et d'autre de la tranchée primaire T1' gravée à l'étape 601. Les tranchées tertiaires T3' sont parallèles aux premières lignes L1 dans le plan de couche P.

Une tranchée tertiaire T3' est gravée de manière que les bords de cette tranchée tertiaire T3' soient sensiblement de même hauteur et que les flancs de la tranchée tertiaire T3' soient compris dans des plans orthogonaux au fond de la tertiaire T3' et sensiblement parallèles entre eux.

La gravure suivant une étape de photo-lithographie peut être réalisée par voie sèche sous plasma fluoré.

Les tranchées tertiaires T3' ont par exemple une largeur de 0,5 µm à 10 µm.

[Fig. 10] La figure 10 illustre une dixième étape 510 du procédé 500 selon le premier mode de réalisation.

La dixième étape 510 consiste à graver la couche métallique d'électrode 110 de manière à conserver la couche métallique d'électrode 110 au niveau des tranchées T1, T2, T1', T2' précédemment gravées.

La dixième étape 510 est également réalisée dans le procédé 600, 700, 800 selon les deuxième, troisième et quatrième modes de réalisation après la neuvième étape 509.

Ainsi à l'issue de la dixième étape 510, les parties de la couche métallique d'électrode 110 localisées dans les premières tranchées T1 deviennent les électrodes de source S, les parties de la couche métallique d'électrode 110 localisées dans les deuxièmes tranchées T2 deviennent les électrodes de drain D et les parties de la couche métallique d'électrode 110 localisées dans les éventuelles tranchées primaires T1', secondaires T2' et tertiaire T3', deviennent une ou plusieurs deuxièmes zones 201, 401, 402 métalliques.

Sur les figures 10, 14, 16 et 17 est représenté le chemin de conduction des électrons entre l'électrode de source S et l'électrode de drain D pour le dispositif 100, 200, 300, 400 respectivement selon le premier, deuxième, troisième et quatrième mode de réalisation dans l'état passant.

On constate que, contrairement aux transistors à gaz d'électrons classiques, le chemin de conduction n'est pas rectiligne et les électrons en provenance de l'électrode de source S traversent la deuxième couche semiconductrice 102 via une deuxième zone 108, 201, 401 pour rejoindre l'électrode de drain D.

[Fig. 25] La figure 25 représente les caractéristiques d'un transistor TR selon l'invention dans son état passant en fonction de l'épaisseur de la deuxième couche semiconductrice 102.

On constate que plus l'épaisseur de la deuxième couche semiconductrice 102 augmente, plus la résistance du transistor TR dans son état passant diminue. Pour une épaisseur de 30 nm, on retrouve la caractéristique souhaitée pour l'état passant comme illustrée sur la figure 24.

[Fig. 26] La figure 26 représente les caractéristiques d'un transistor TR selon l'invention dans son état passant en fonction du pourcentage d'aluminium Al dans la deuxième couche semiconductrice 102 en nitrure d'aluminium-gallium.

On constate que plus le pourcentage d'aluminium augmente, plus la résistance du transistor TR dans son état passant diminue. Pour un pourcentage d'aluminium de 22%, on retrouve la caractéristique souhaitée pour l'état passant comme illustrée sur la figure 24.

[Fig. 27] La figure 27 représente les caractéristiques d'un transistor TR selon l'invention dans son état bloqué en fonction de la concentration en dopants dans la troisième couche semiconductrice 103.

On constate que plus la concentration en dopants augmente, plus la résistance du transistor TR dans son état bloqué augmente et donc plus la tension de seuil augmente. Pour une concentration en dopants de 10¹⁹ cm⁻³, on retrouve la caractéristique souhaitée pour l'état bloqué comme illustrée sur la figure 24.

La résistance du transistor TR dans l'état passant peut donc être réglée par l'intermédiaire des caractéristiques de la deuxième couche semiconductrice 102 et la résistance dans l'état bloqué et donc la tension de seuil, par l'intermédiaire des caractéristiques de la troisième couche semiconductrice 103.

Ainsi, la résistance du transistor TR dans son état passant est décorrélée de sa tension de seuil, contrairement aux transistors à gaz d'électrons classiques dans lesquels les caractéristiques de la deuxième couche semiconductrice 102 impactent aussi la résistance dans l'état bloqué.

[Fig. 28] La figure 28 représente en pointillés noir le courant de fuite d'un transistor TR selon l'invention présentant une troisième couche semiconductrice en nitrure de gallium GaN dopé P et en pointillés rouge le courant de fuite d'un transistor TR selon l'invention présentant une troisième couche semiconductrice en nitrure d'aluminium-gallium GaN dopée P avec un gradient d'aluminium selon l'axe vertical Y présentant une première fraction molaire en aluminium égale à 0.2 et une deuxième fraction molaire en aluminium nulle. Dans les deux cas, la troisième couche semiconductrice est dopée avec du magnésium Mg avec une concentration en dopants de l'ordre de 5 x10¹⁸ cm⁻³.

On constate que le courant de fuite dans le transistor TR présentant une troisième couche semiconductrice en nitrure d'aluminium-gallium GaN dopé P avec un gradient vertical d'aluminium est inférieur au courant de fuite dans le transistor TR selon l'invention présentant une troisième couche semiconductrice en nitrure de gallium GaN dopé P.

Le dispositif monobloc selon le deuxième aspect de l'invention peut comporter en outre une diode Schottky intégrée en parallèle de chaque transistor TR.

[Fig. 31] La figure 31 montre une représentation schématique d'une première variante de réalisation d'un transistor TR d'un cinquième mode de réalisation du dispositif 1100 selon l'invention, intégrant une diode Schottky.

[Fig. 34] La figure 34 montre une représentation schématique d'une première variante de réalisation d'un transistor TR d'un sixième mode de réalisation du dispositif 1200 selon l'invention, intégrant une diode Schottky.

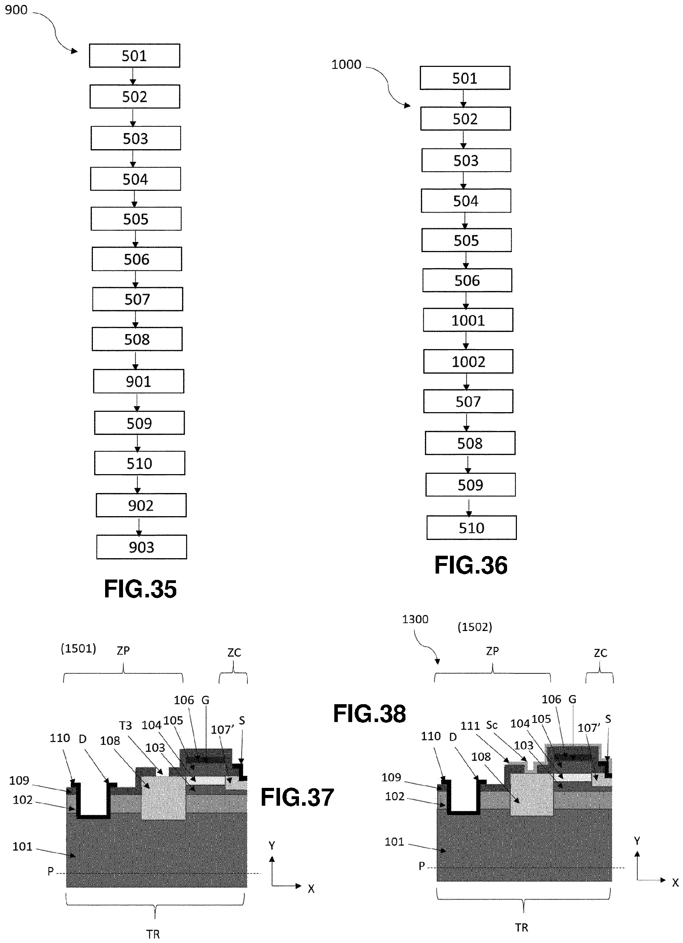

[Fig. 38] La figure 38 montre une représentation schématique d'un transistor TR d'un septième mode de réalisation du dispositif 1300 selon l'invention, intégrant une diode Schottky.

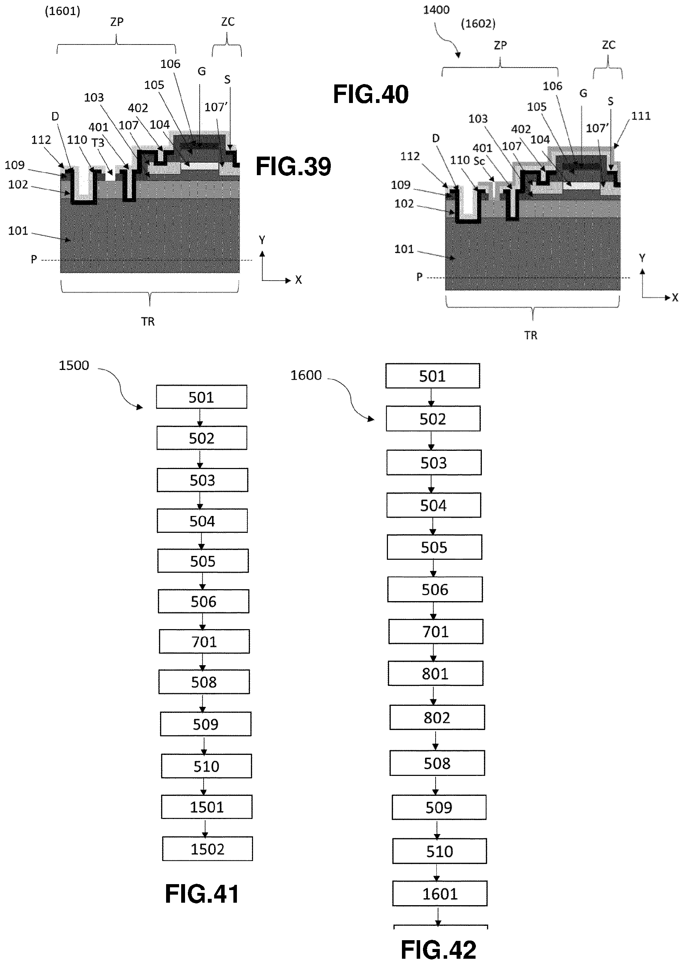

[Fig. 40] La figure 40 montre une représentation schématique d'un transistor TR d'un huitième mode de réalisation du dispositif 1400 selon l'invention, intégrant une diode Schottky.

[Fig. 35] La figure 35 est un schéma synoptique illustrant les étapes d'une première variante de réalisation du cinquième mode de réalisation du procédé 900 selon l'invention permettant d'obtenir la première variante de réalisation du cinquième mode de réalisation du dispositif 1100 selon l'invention.

Le cinquième mode de réalisation du procédé 900 selon l'invention comporte en outre trois étapes par rapport au premier mode de réalisation 500, ou au deuxième mode de réalisation 600 du procédé selon l'invention.

La première variante de réalisation du cinquième mode de réalisation du dispositif 1100 selon l'invention permet d'obtenir le cinquième mode de réalisation du dispositif 1100 selon l'invention à partir du premier mode de réalisation du dispositif 100 selon l'invention. Les mêmes enseignements pourront être appliqués pour obtenir une deuxième variante de réalisation du cinquième mode de réalisation du dispositif 1100 selon l'invention à partir du deuxième mode de réalisation du dispositif 200 selon l'invention.

Le cinquième mode de réalisation du procédé 900 selon l'invention comporte les huit premières étapes 501, 502, 503, 504, 505, 506, 507, 508 du premier mode de réalisation du procédé 500 selon l'invention.

[Fig. 29] La figure 29 illustre une neuvième étape 901 de la première variante de réalisation du cinquième mode de réalisation du procédé 900 selon l'invention.

La neuvième étape 901 pourrait être réalisée avant les étapes 507 et 508 de gravure des premières tranchées T1 et des deuxièmes tranchées T2.

La neuvième étape 901 consiste à graver deux troisièmes tranchées T3 parallèles dans la couche isolante d'électrode 109, au niveau des zones périphériques ZP situées de part et d'autre des deux deuxièmes lignes L2 de manière que les deuxièmes lignes L2 soient entre les deux troisièmes tranchées T3.

Chaque troisième tranchée T3 est entre une première tranchée T1 et une deuxième tranchée T2.

Les troisièmes tranchées T3 sont parallèles aux premières tranchées T1 et aux deuxièmes tranchées T2.

La gravure suivant une étape de photo-lithographie peut être réalisée par voie sèche sous plasma fluoré.

La neuvième étape 901 est suivie de la neuvième étape 509 et de la dixième étape 510 du premier mode de réalisation du procédé 500 selon l'invention, correspondant respectivement au dixième et onzième étape de la première variante de réalisation du cinquième mode de réalisation du procédé 900 selon l'invention, la gravure d'électrodes réalisée lors de la dixième étape 510 conservant en outre la couche métallique d'électrode 110 entre chaque troisième tranchée T3 gravée à la neuvième étape 901 et la première tranchée T1 la plus proche de la troisième tranchée T3 considérée.

La dixième étape 510 du premier mode de réalisation du procédé 500 selon l'invention est suivie d'une douzième étape et d'une treizième étape dans le procédé 900.

[Fig. 30] La figure 30 illustre la douzième étape 902 de la première variante de réalisation du cinquième mode de réalisation du procédé 900 selon l'invention.

[Fig. 31] La figure 31 illustre la treizième étape 903 de la première variante de réalisation du cinquième mode de réalisation du procédé 900 selon l'invention.

La douzième étape 902 consiste à déposer une couche métallique de diode 111 selon le plan de couche P.

Le dépôt est par exemple réalisé par CVD pour « Chemical Vapor Déposition » ou par pulvérisation ou sputtering en anglais.

La couche métallique de diode 111 est par exemple en Ni ou Ni-Au et a une épaisseur comprise entre 10 nm et 500 nm.

La treizième étape 903 consiste à graver la couche métallique de diode 111 de manière à conserver au moins la couche métallique de diode 111 au niveau de chaque troisième tranchée T3 gravée à la neuvième étape 901 et entre chaque troisième tranchée T3 et la première tranchée T1 la plus proche de la troisième tranchée T3 considérée.

La couche métallique de diode 111 restante constitue une diode Schottky Sc.

A l'issue de la treizième étape 903, la première variante de réalisation du cinquième mode de réalisation du dispositif 1100 selon l'invention est obtenue.

[Fig. 36] La figure 36 est un schéma synoptique illustrant les étapes d'une première variante de réalisation du sixième mode de réalisation du procédé 1000 selon l'invention permettant d'obtenir la première variante de réalisation du sixième mode de réalisation du dispositif 1200 selon l'invention.

Le sixième mode de réalisation du procédé 1000 selon l'invention comporte en outre deux étapes par rapport au premier mode de réalisation 500, ou au deuxième mode de réalisation 600 du procédé selon l'invention.

La première variante de réalisation du sixième mode de réalisation du dispositif 1200 selon l'invention permet d'obtenir le sixième mode de réalisation du dispositif 1200 selon l'invention à partir du premier mode de réalisation du dispositif 100 selon l'invention. Les mêmes enseignements pourront être appliqués pour obtenir une deuxième variante de réalisation du sixième mode de réalisation du dispositif 1100 selon l'invention à partir du deuxième mode de réalisation du dispositif 200 selon l'invention.

Le sixième mode de réalisation du procédé 1000 selon l'invention comporte les six premières étapes 501, 502, 503, 504, 505, 506, du premier mode de réalisation du procédé 500 selon l'invention.

[Fig. 32] La figure 32 illustre une septième étape 1001 de la première variante de réalisation du sixième mode de réalisation du procédé 1000 selon l'invention.

La septième étape 1001 consiste à graver deux troisièmes tranchées T3 parallèles dans la couche isolante d'électrode 109, au niveau des zones périphériques ZP situées de part et d'autre des deux deuxièmes lignes L2 de manière que les deuxièmes lignes L2 soient entre les deux troisièmes tranchées T3.

La gravure suivant une étape de photo-lithographie peut être réalisée par voie sèche sous plasma fluoré.

La septième étape 1001 consiste ensuite à déposer une couche métallique de diode 111 selon le plan de couche P.

Le dépôt est par exemple réalisé par CVD pour « Chemical Vapor Déposition » ou par pulvérisation ou sputtering en anglais.

La couche métallique de diode 111 est par exemple en Ni ou Ni-Au et a une épaisseur comprise entre 10 nm et 500 nm.

[Fig. 33] La figure 32 illustre la huitième étape 1002 de la première variante de réalisation du sixième mode de réalisation du procédé 1000 selon l'invention.

La huitième étape 1002 consiste à graver la couche métallique de diode 111 de manière à conserver au moins la couche métallique de diode 111 au niveau de chaque troisième tranchée T3, entre chaque troisième tranchée T3 et la deuxième ligne L2 la plus proche de la troisième tranchée T3 considéré et au niveau de chaque deuxième ligne L2.

La huitième étape 1002 consiste ensuite à déposer une couche isolante de diode 112 selon le plan de couche P.

La couche isolante d'électrode de diode 112 est par exemple en nitrure de silicium SiN et a par exemple une épaisseur comprise entre 10 et 500 nm.

La couche isolante d'électrode de diode 112 est par exemple obtenue par dépôt LPCVD d'une souche de SiN.

La huitième étape 1002 est suivie de la septième étape 507, de la huitième étape 508, de la neuvième étape 509 et de la dixième étape 510 du premier mode de réalisation du procédé 500 selon l'invention, correspondant respectivement au neuvième, dixième, onzième et douzième étape de la première variante de réalisation du sixième mode de réalisation du procédé 1000 selon l'invention, les deuxièmes tranchées T2 étant gravées de manière que les troisièmes tranchées T3 soient entre les deuxièmes tranchées T2 et la gravure d'électrodes réalisée lors de la dixième étape 510 conservant en outre la couche métallique d'électrode 110 dans chaque troisième tranchée T3 et entre chaque troisième tranchée T3 et la première tranchée T1 la plus proche de la troisième tranchée T3 considérée.

A l'issue du procédé 1000, chaque troisième tranchée T3 est entre une première tranchée T1 et une deuxième tranchée T2 et les troisièmes tranchées T3 sont parallèles aux premières tranchées T1 et aux deuxièmes tranchées T2.

A l'issue de la douzième étape 510, la première variante de réalisation du sixième mode de réalisation du dispositif 1200 selon l'invention illustrée à la figure 34 est obtenue, la couche métallique de diode 111 restante recouverte de la couche métallique d'électrode 110 constituant une diode Schottky Sc.

[Fig. 41] La figure 41 est un schéma synoptique illustrant les étapes du septième mode de réalisation du procédé 1500 selon l'invention permettant d'obtenir le septième mode de réalisation du dispositif 1300 selon l'invention.

Le septième mode de réalisation du procédé 1500 selon l'invention comporte en outre deux étapes par rapport au troisième mode de réalisation 700 du procédé selon l'invention.

Le septième mode de réalisation du dispositif 1300 selon l'invention permet d'obtenir le septième mode de réalisation du dispositif 1300 selon l'invention à partir du troisième mode de réalisation du dispositif 300 selon l'invention.

Le septième mode de réalisation du procédé 1500 selon l'invention comporte les dix étapes 501, 502, 503, 504, 505, 506, 701, 508, 509, 510 du troisième mode de réalisation du procédé 700 selon l'invention.

[Fig. 37] La figure 37 illustre la onzième étape 1501 du septième mode de réalisation du procédé 1500 selon l'invention.

La onzième étape 1501 consiste à graver deux troisièmes tranchées T3 parallèles de manière que chaque troisième tranchée soit gravée au niveau d'une deuxième ligne L2.

Chaque troisième tranchée T3 est entre la première tranchée T1 et une deuxième tranchée T2 et les troisièmes tranchées T3 sont parallèles à la première tranchée T1 et aux deuxièmes tranchées T2.

La gravure suivant une étape de photo-lithographie peut être réalisée par voie sèche sous plasma fluoré.

[Fig. 38] La figure 38 illustre la douzième étape 1502 du septième mode de réalisation du procédé 1500 selon l'invention.

La douzième étape 1502 consiste à déposer une couche métallique de diode 111 selon le plan de couche P.

Le dépôt est par exemple réalisé par CVD pour « Chemical Vapor Déposition » ou par pulvérisation ou sputtering en anglais.

La couche métallique de diode 111 est par exemple en Ni ou Ni-Au et a une épaisseur comprise entre 10 nm et 500 nm.

La douzième étape 1502 consiste ensuite à graver la couche métallique de diode 111 de manière à conserver au moins la couche métallique de diode 111 au niveau de chaque deuxième ligne L2, entre chaque troisième tranchée T3 et la première tranchée T1 et au niveau de la première tranchée T1.

A l'issue de la douzième étape 1502, le septième mode de réalisation du dispositif 1300 selon l'invention illustrée à la figure 38 est obtenue, la couche métallique de diode 111 restante constituant une diode Schottky Sc.

[Fig. 42] La figure 42 est un schéma synoptique illustrant les étapes du huitième mode de réalisation du procédé 1600 selon l'invention permettant d'obtenir le huitième mode de réalisation du dispositif 1400 selon l'invention.

Le huitième mode de réalisation du procédé 1600 selon l'invention comporte en outre deux étapes par rapport au quatrième mode de réalisation du procédé 800 selon l'invention.

Le huitième mode de réalisation du dispositif 1400 selon l'invention permet d'obtenir le huitième mode de réalisation du dispositif 1400 selon l'invention à partir du quatrième mode de réalisation du dispositif 400 selon l'invention.

Le huitième mode de réalisation du procédé 1600 selon l'invention comporte les douze étapes 501, 502, 503, 504, 505, 506, 701, 801, 802, 508, 509, 510 du quatrième mode de réalisation du procédé 800 selon l'invention.

[Fig. 39] La figure 39 illustre la treizième étape 1601 du huitième mode de réalisation du procédé 1600 selon l'invention.

La treizième étape 1601 consiste à déposer une couche isolante de diode 112 selon le plan de couche P.

La couche isolante d'électrode de diode 112 est par exemple en nitrure de silicium SiN et a par exemple une épaisseur comprise entre 10 et 500 nm.

La couche isolante d'électrode de diode 112 est par exemple obtenue par dépôt LPCVD d'une souche de SiN.

La treizième étape 1601 consiste ensuite à graver deux troisièmes tranchées T3 parallèles de manière que chaque troisième tranchée soit gravée entre une deuxième tranchée T2 et une tranchée secondaire T2'.

Les troisièmes tranchées T3 sont parallèles à la première tranchée T1, aux tranchées primaires T1', aux tranchées secondaires T2' et aux deuxièmes tranchées T2.

La gravure suivant une étape de photo-lithographie peut être réalisée par voie sèche sous plasma fluoré.

[Fig. 40] La figure 40 illustre la quatorzième étape 1602 du huitième mode de réalisation du procédé 1600 selon l'invention.

La quatorzième étape 1602 consiste à déposer une couche métallique de diode 111 selon le plan de couche P.

Le dépôt est par exemple réalisé par CVD pour « Chemical Vapor Déposition » ou par pulvérisation ou sputtering en anglais.

La couche métallique de diode 111 est par exemple en Ni ou Ni-Au et a une épaisseur comprise entre 10 nm et 500 nm.

La quatorzième étape 1602 consiste ensuite à graver la couche métallique de diode 111 de manière à conserver au moins la couche métallique de diode 111 au niveau de chaque troisième tranchée T3, entre chaque troisième tranchée T3 et la première tranchée T1 et au niveau de la première tranchée T1.

A l'issue de la quatorzième étape 1602, le huitième mode de réalisation du dispositif 1400 selon l'invention illustrée à la figure 40 est obtenue, la couche métallique de diode 111 restante constituant une diode Schottky Sc.

## Revendications

1. Transistor (TR) à gaz d'électrons de type normalement ouvert, **caractérisé en ce qu'**il comporte :
- une première couche semiconductrice (101) agencée selon un plan de couche (P) et une deuxième couche semiconductrice (102) formée sur la première couche semiconductrice (101) et agencée selon le plan de couche (P), les première (101) et deuxième couches semiconductrices (102) formant une couche de gaz d'électrons à leur interface ;
- une troisième couche semiconductrice (103) à dopage de type P formée sur la deuxième couche semiconductrice (102) et agencée selon le plan de couche (P),
- au moins une première zone (107, 107') à dopage de type N dont au moins une partie est ménagée dans l'épaisseur de la troisième couche semiconductrice (103), la première zone (107) délimitant une zone de source (107') ;
- au moins une deuxième zone (108, 201, 401, 402) à dopage de type N ou métallique présentant au moins une partie ménagée dans la deuxième couche semiconductrice (102) ;
- une électrode de source (S) formée sur la zone de source (107') ;
- une électrode de drain (D) formée sur la première couche semiconductrice (101) ; et
- une grille (G) localisée entre l'électrode de source (S) et la deuxième zone (108, 201, 401, 402).

2. Transistor (TR) selon la revendication 1, **caractérisé en ce qu'**il comporte en outre une quatrième couche semiconductrice (104) sur la troisième couche semiconductrice (103) agencée selon le plan de couche (P), la zone de source (107') et au moins une partie de la deuxième zone (108, 201, 401) étant ménagées dans l'épaisseur de la quatrième couche semiconductrice (104).

3. Transistor (TR) selon la revendication 2, **caractérisé en ce que** la quatrième couche semiconductrice (104) est une couche de nitrure de gallium GaN intrinsèque.

4. Transistor (TR) selon l'une quelconque des revendications précédentes, **caractérisé en ce que** la première couche semiconductrice (101) est une couche de nitrure de gallium GaN et la deuxième couche semiconductrice (102) est une couche de nitrure d'aluminium-gallium AIGaN.

5. Transistor (TR) selon la revendication 4, **caractérisé en ce que** le taux d'aluminium dans la deuxième couche semiconductrice (102) est supérieur à 20%.

6. Transistor (TR) selon l'une quelconque des revendications précédentes, **caractérisé en ce que** la deuxième couche semiconductrice (102) a une épaisseur supérieure à 20 nm.

7. Transistor (TR) selon l'une quelconque des revendications précédentes, **caractérisé en ce que** la troisième couche semiconductrice (103) est une couche de nitrure de gallium GaN dopée avec du magnésium Mg avec une concentration de dopants de l'ordre de 10¹⁷ ou 10¹⁸ cm⁻³.

8. Transistor (TR) selon l'une quelconque des revendications 1 à 6, **caractérisé en ce que** la troisième couche semiconductrice (103) est une couche de nitrure d'aluminium gallium AIGaN dopée avec du magnésium Mg avec une concentration de dopants de l'ordre 10¹⁷ ou 10¹⁸ cm⁻³ avec un gradient d'aluminium selon un axe (Y) perpendiculaire au plan des couches (P), allant d'une première fraction molaire en aluminium pour la partie de la troisième couche semiconductrice (103) en contact avec la deuxième couche semiconductrice (102) à une deuxième fraction molaire en aluminium inférieure à la première fraction molaire en aluminium.

9. Transistor (TR) selon l'une quelconque des revendications précédentes, **caractérisé en ce que** la première zone (107) est dopée avec du silicium Si avec une concentration de dopants de l'ordre de 10¹⁹ cm⁻³ à 10²⁰ cm⁻³ et a une épaisseur comprise entre 10 nm et 100 nm.

10. Transistor (TR) selon l'une quelconque des revendications précédentes, **caractérisé en ce que** la deuxième zone (108) à dopage de type N est dopée avec du silicium Si avec une concentration de dopants de l'ordre de 10²⁰ cm⁻³.

11. Transistor (TR) selon l'une quelconque des revendications précédentes, **caractérisé en ce que** la troisième couche semiconductrice (103) a une épaisseur comprise entre 50 et 200 nm.

12. Transistor (TR) selon l'une quelconque des revendications précédentes, **caractérisé en ce que** la deuxième zone (108, 201) présente au moins une partie ménagée dans l'épaisseur des troisième (103), deuxième (102) et première couche semiconductrice (101).

13. Transistor (TR) selon l'une quelconque des revendications 1 à 11, **caractérisé en ce qu'**une première deuxième zone (401) métallique présente au moins une partie ménagée dans l'épaisseur des deuxième (102) et première couches semiconductrices (101) et une deuxième deuxième zone (402) métallique située entre la source (S) et la première deuxième zone (401) présente au moins une partie ménagée dans une première zone (107).

14. Dispositif monobloc (100, 200, 300, 400, 1100, 1200, 1300, 1400) comportant au moins deux transistors (TR) selon l'une quelconque des revendications précédentes, disposés en cascode.

15. Dispositif monobloc (1100, 1200, 1300, 1400) selon la revendication 14, comportant en outre une diode Schottky (Sc) intégrée en parallèle de chaque transistor (TR).

16. Procédé (500, 600, 700, 800, 900, 1000, 1500, 1600) de fabrication d'un dispositif (100, 200, 300, 400, 1100, 1200, 1300, 1400) selon la revendication 14 ou 15, **caractérisé en ce qu'**il comporte les étapes suivantes :
- dépôt (501) selon un plan de couche (P), d'une première (101) puis d'une deuxième (102) puis d'une troisième couche semiconductrice (103) puis d'une couche isolante de grille (105) et puis d'une couche métallique de grille (106) ;
- gravure (502) de la couche isolante de grille (105) et de la couche métallique de grille (106) de manière à obtenir deux premières lignes (L1) parallèles et non confondues dans le plan de couche (P) ;
- dopage (503) d'au moins la troisième couche semiconductrice (103) au niveau de zones périphériques (ZP) situées de part et d'autre des deux premières lignes (L1) et agencées selon le plan de couche (P) ;
- dopage (504) d'au moins la troisième couche semiconductrice (103) au niveau d'une zone centrale (ZC) située entre les deux premières lignes (L1) et agencée selon le plan de couche (P) ;
- gravure (505) des zones périphériques (ZP) avec arrêt sur la deuxième couche semiconductrice (102) de manière à conserver une deuxième ligne (L2) le long de chaque première ligne (L1) ;
- dépôt (506) d'une couche isolante d'électrode (109) selon le plan de couche (P) ;
- gravure (508) de deux deuxièmes tranchées (T2) parallèles avec arrêt sur ou dans la première couche semiconductrice (101) dans les zones périphériques (ZP) situées de part et d'autre des deux deuxièmes lignes (L2), les deuxièmes lignes (L2) étant entre les deux deuxièmes tranchées (T2) ;
- dépôt (509) d'une couche métallique d'électrode (110) selon le plan de couche (P) ;
- gravure (510), dite gravure d'électrodes, de la couche métallique d'électrode (110) de manière à conserver au moins la couche métallique d'électrode (110) au niveau des deuxièmes tranchées (T2).

17. Procédé (500, 600, 900, 1000) selon la revendication 16, **caractérisé en ce qu'**il comporte en outre une gravure (507) d'une première tranchée (T1) dans la couche isolante d'électrode (109) au niveau de chaque deuxième ligne (L2), la gravure d'électrodes (510) conservant la couche métallique d'électrode (110) au niveau des deux premières tranchées (T1).

18. Procédé (600, 900, 1000) selon la revendication 17, **caractérisé en ce qu'**il comporte en outre les étapes suivantes :
- gravure (601) d'une tranchée primaire (T1') dans la zone centrale (ZC) avant l'étape de dépôt (506) de la couche isolante d'électrode (109) ;
- gravure (602) d'une tranchée secondaire (T2') dans la tranchée primaire (T1') avec arrêt dans la première couche semiconductrice (101) après l'étape de dépôt (506) de la couche isolante d'électrode (109),
- gravure (603) d'au moins deux tranchées tertiaires (T3') dans la zone centrale de part et d'autre de la tranchée primaire (T1') après l'étape de dépôt (506) de la couche isolante d'électrode (109) ;
la gravure d'électrodes (510) conservant la couche métallique d'électrode (110) au niveau des tranchées primaire (T1'), secondaire (T2') et tertiaires (T3').

19. Procédé (700, 800, 1500, 1600) de fabrication selon la revendication 16, **caractérisé en ce qu'**il comporte en outre, après l'étape de dépôt (506) de la couche isolante d'électrode (109), une gravure (701) d'une première tranchée (T1) dans la zone centrale (ZC), la gravure d'électrodes (510) conservant la couche métallique d'électrode (110) au niveau de la première tranchée (T1).

20. Procédé (800, 1600) de fabrication selon la revendication 19, **caractérisé en ce qu'**il comporte en outre les étapes suivantes, après l'étape de dépôt (506) de la couche isolante d'électrode (109) :
- gravure (801) d'une tranchée primaire (T1') dans au moins la couche isolante d'électrode (109) au niveau de chaque deuxième ligne (L2) ;
- gravure (802) d'une tranchée secondaire (T2') avec arrêt sur la première couche semiconductrice (101) le long de chaque deuxième ligne (L2),
la gravure d'électrodes (510) conservant la couche métallique d'électrode (110) au niveau des deux tranchées primaires (T1') et deux tranchées secondaires (T2').

21. Procédé (900) de fabrication selon la revendication 17 ou 18 d'un dispositif (1100) selon la revendication 15, **caractérisé en ce qu'**il comporte, après l'étape de dépôt (506) de la couche isolante d'électrode (109), une étape de gravure (901) de deux troisièmes tranchées (T3) parallèles dans la couche isolante d'électrode (109), dans les zones périphériques (ZP) situées de part et d'autre des deux deuxièmes lignes (L2), les deuxièmes lignes (L2) étant entre les deux troisièmes tranchées (T3), les deuxièmes tranchées (T2) étant gravées de manière que les troisièmes tranchées (T3) soient entre les deuxièmes tranchées (T2), la gravure d'électrodes (510) conservant en outre la couche métallique d'électrode (110) entre chaque troisième tranchée (T3) et la première tranchée (T1) la plus proche et après l'étape de gravure d'électrodes (510), les étapes suivantes :
- dépôt (902) d'une couche métallique de diode (111) selon le plan de couche (P) ;
- gravure (903) de la couche métallique de diode (111) de manière à conserver au moins la couche métallique de diode (111) au niveau de chaque troisième tranchée (T3) et entre chaque troisième tranchée (T3) et la première tranchée (T1) la plus proche.

22. Procédé (1000) de fabrication selon la revendication 17 ou 18 d'un dispositif (1200) selon la revendication 15, **caractérisé en ce qu'**il comporte en outre, après l'étape de dépôt (506) de la couche isolante d'électrode (109), les étapes suivantes :
- gravure de deux troisièmes tranchées (T3) parallèles dans la couche isolante d'électrode (109), dans les zones périphériques (ZP) situées de part et d'autre des deux deuxièmes lignes (L2), les deuxièmes lignes (L2) étant entre les deux troisièmes tranchées (T3), puis dépôt d'une couche métallique de diode (111) selon le plan de couche (P, 1001) ;
- gravure de la couche métallique de diode (111) de manière à conserver au moins la couche métallique de diode (111) au niveau de chaque troisième tranchée (T3), entre chaque troisième tranchée (T3) et la deuxième ligne (L2) la plus proche et au niveau de chaque deuxième ligne (L2), puis dépôt d'une couche isolante de diode (112) selon le plan de couche (P, 1002) ;
les deuxièmes tranchées (T2) étant gravées de manière que les troisièmes tranchées (T3) soient entre les deuxièmes tranchées (T2), la gravure d'électrodes (510) conservant en outre la couche métallique d'électrode (110) au niveau de chaque troisième tranchée (T3) et entre chaque troisième tranchée (T3) et la première tranchée (T1) la plus proche.

23. Procédé (1500) de fabrication selon la revendication 19 d'un dispositif (1300) selon la revendication 15, **caractérisé en ce qu'**il comporte en outre, après l'étape de gravure d'électrodes (510), les étapes suivantes :
- gravure (1501) de deux troisièmes tranchées (T3) parallèles, chaque troisième tranchée (T3) étant gravée au niveau d'une deuxième ligne (L2) ;
- dépôt d'une couche métallique de diode (111) selon le plan de couche (P) et gravure de la couche métallique de diode (111) de manière à conserver au moins la couche métallique de diode (111) au niveau chaque deuxième ligne (L2), entre chaque troisième tranchée (T3) et la première tranchée (T1) et au niveau de la première tranchée (T1, 1502).

24. Procédé (1600) de fabrication selon la revendication 20 d'un dispositif (1400) selon la revendication 15, **caractérisé en ce qu'**il comporte en outre, après l'étape de gravure d'électrodes (510), les étapes suivantes :
- dépôt d'une couche isolante de diode (112) selon le plan de couche (P) et gravure de deux troisièmes tranchées (T3) parallèles, chaque troisième tranchée (T3) étant gravée entre une deuxième tranchée (T2) et une tranchée secondaire (T2', 1601) ;
- dépôt d'une couche métallique de diode (111) selon le plan de couche (P) et gravure de la couche métallique de diode (111) de manière à conserver au moins la couche métallique de diode (111) au niveau de chaque troisième tranchée (T3), entre chaque troisième tranchée (T3) et la première tranchée (T1) et au niveau de la première tranchée (T1, 1602).
